(19) Europäisches Patentamt
European Patent Office
Office européen des brevets

(11) **EP 4 081 839 B1**

(12) **EUROPÄISCHE PATENTSCHRIFT**

(45) Veröffentlichungstag und Bekanntmachung des Hinweises auf die Patenterteilung:
**28.01.2026 Patentblatt 2026/05**

(21) Anmeldenummer: **20792567.8**

(22) Anmeldetag: **09.10.2020**

(51) Internationale Patentklassifikation (IPC):
*F24S 23/70* (2018.01)    *H10F 77/42* (2025.01)
*G02B 3/08* (2006.01)    *F24S 23/00* (2018.01)
*B82Y 20/00* (2011.01)

(52) Gemeinsame Patentklassifikation (CPC):
**G02B 3/08; F24S 23/12; H10F 77/42; H10F 77/484;**
B82Y 20/00; F24S 2023/85; F24S 2023/86;
G02B 2207/101; Y02E 10/40; Y02E 10/52

(86) Internationale Anmeldenummer:
**PCT/EP2020/078381**

(87) Internationale Veröffentlichungsnummer:
**WO 2021/129962 (01.07.2021 Gazette 2021/26)**

(54) **LICHTKONZENTRATOR**

LIGHT CONCENTRATOR

CONCENTRATEUR DE LUMIÈRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.12.2019 DE 102019135672**
**16.01.2020 DE 102020100960**

(43) Veröffentlichungstag der Anmeldung:
**02.11.2022 Patentblatt 2022/44**

(73) Patentinhaber: **Bergische Universität Wuppertal**
**42119 Wuppertal (DE)**

(72) Erfinder:
• **GÖRRN, Patrick**
  **42119 Wuppertal (DE)**
• **MEUDT, Maik**
  **42105 Wuppertal (DE)**

(74) Vertreter: **Cohausz Hannig Borkowski Wißgott**
**Patentanwaltskanzlei GbR**
**Grafenberger Allee 337a**
**40235 Düsseldorf (DE)**

(56) Entgegenhaltungen:
EP-A1- 2 061 092    WO-A1-2008/131561
WO-A2-2010/033632    WO-A2-2012/014088

EP 4 081 839 B1

**Beschreibung**

Die Erfindung betrifft einen Lichtkonzentrator umfassend wenigstens einen Wellenleiter, bevorzugt umfassend einen geschichteten, insbesondere in Z-Richtung geschichteten Stapel von wenigstens zwei Wellenleitern, wobei der wenigstens eine Wellenleiter zwischen zwei Schichtanordnungen von jeweils wenigstens zwei in einer Schichtungsrichtung geschichteten, transparenten dielektrischen Schichten eine lichtablenkende Struktur aufweist, mit welcher auf den wenigstens einen Wellenleiter einfallendes Licht wenigstens eines vorbestimmten Wellenlängenbereiches in den Wellenleiter hinein lenkbar ist, wobei in dem Wellenleiter durch Totalreflexion wenigstens eine Mode des wenigstens einen vorbestimmten Wellenlängenbereiches führbar ist, die in der Schichtungsrichtung betrachtet in ihrer Intensitätsverteilung wenigstens ein, bevorzugt genau ein lokales Intensitätsminimum aufweist, welches innerhalb der lichtablenkenden Struktur angeordnet ist

Ein Lichtkonzentrator der eingangs genannten Art ist z.B. bekannt aus der Publikation EP 3 164 744 A1 derselben Anmelderin.

Ein solcher Lichtkonzentrator ist auch bekannt aus der Publikation EP 2 061 092 A1.

Die nachfolgende Beschreibung eines Lichtkonzentrators bzw. Wellenleiters trifft vorzugsweise auch auf die später beschriebene Erfindung zu.

Ein Lichtkonzentrator der Erfindung kann einen einzigen Wellenleiter der genannten Konstruktionsart aufweisen, bevorzugt aber auch einen Stapel von wenigstens zwei in einer Stapelungsrichtung gestapelten Wellenleitern, insbesondere wobei die Stapelungsrichtung parallel zur Schichtungsrichtung ist. Nachfolgende Ausführungen gelten sowohl für einen evtl. einzigen Wellenleiter, als auch für jeden von mehreren gestapelten Wellenleitern eines Lichtkonzentrators der Erfindung.

Für ein besseres Verständnis der Erfindung kann angenommen sein, dass die Schichten der Schichtanordnungen in einem in Bezug genommenen Koordinatensystem in dessen Z-Richtung geschichtet sind. In gleicher Weise sind ggfs. gestapelte Wellenleiter in der Z-Richtung gestapelt. Die wenigstens zwei Schichten der jeweiligen Schichtanordnung sind sodann bevorzugt parallel zu einer senkrecht zu Z stehenden Ebene, z.B. also parallel zu einer X-Y-Ebene eines kartesischen Koordinatensystems oder parallel zu einer von $\rho$ und $\varphi$ aufgespannten Ebene eines Zylinderkoordinatensystems angeordnet. Die jeweiligen gesamten Schichtanordnungen sind demnach in derselben Richtung erstreckt.

Bei einem Wellenleiter ist es vorgesehen, dass auf eine äußere Schicht einer der Schichtanordnungen einfallendes und durch diese (erste) Schichtanordnung transmittierendes Licht durch die lichtablenkende Struktur in den Wellenleiter hinein lenkbar ist. Bevorzugt gilt dies zumindest für Licht, das aus wenigstens einer vorbestimmten Richtung, bzw. mit einem vorbestimmten zwischen der Z-Achse und der Einfallsrichtung eingeschlossenen Einfallswinkel $\theta_{ein}$ auf den Wellenleiter bzw. die äußere Oberfläche von dessen äußersten Schicht einer Schichtanordnung einfällt und bis zur lichtablenkenden Struktur transmittiert. Eine solche vorbestimmte Richtung kann z.B. senkrecht zur Oberfläche der äußersten Schicht einer Schichtanordnung liegen, also parallel zur Z-Richtung. Eine solche senkrechte Einfallsrichtung ist dementsprechend durch $\theta_{ein} = 0$ charakterisiert. Weiterhin gilt dies zumindest für Licht wenigstens einer vorbestimmten Wellenlänge, insbesondere eines vorbestimmten Wellenlängenbereiches.

Hierunter wird bevorzugt verstanden, dass die Ablenkung des einfallenden Lichtes mit dieser vorbestimmten Wellenlänge beziehungsweise dieses vorbestimmten Wellenlängenbereiches in die Richtung der möglichen Propagationsrichtung(en) einer im Wellenleiter führbaren Mode mit einer Propagationskonstanten $\beta$ dieser Wellenlänge bzw. dieses Wellenlängenbereiches erfolgt, d.h. insbesondere, dass die Winkeländerung $\Delta\theta$ durch die Ablenkung die Relation

$$\beta = \frac{2\pi}{\lambda} \cdot n_i \cdot \sin(\theta_{ein}) + P(\theta_{ein}, \lambda)$$

$$\text{mit } P(\theta_{ein}, \lambda) = \frac{2\pi}{\lambda} \sin(\Delta\theta(\theta_{ein}))$$

erfüllt.

Mit Bezug auf das zuvor genannte, angenommene Koordinatensystem erfolgt bevorzugt die Führung des Lichtes einer dielektrischen Mode im Wellenleiter in alle Richtungen senkrecht zur Z-Richtung oder allgemein senkrecht zur Schichtungsrichtung der Schichten und/oder Stapelungsrichtung ggfs. gestapelter Wellenleiter. Diese Richtung, in der die Mode geführt ist, wird auch als lateral bezeichnet, wohingegen die Z-Richtung bzw. die Schichtungsrichtung als normal bezeichnet ist.

Innerhalb des jeweiligen Wellenleiters erfolgt die Führung des Lichtes, insbesondere der geführten Mode an/in den beiden Schichtanordnungen parallel zu den Schichten durch das Prinzip der Totalreflektion.

Insbesondere wird bei stufenweisen Übergängen des Brechungsindexes das Licht an zwei durch solche Übergänge definierten Ebenen, die um die lichtablenkende Struktur herum angeordnet sind, insbesondere also jeweils in einer der beidseits zur lichtablenkenden Struktur angeordneten Schichtanordnungen angeordnet sind, durch Totalreflexion in den inneren Bereich des Wellenleiters zurückgeworfen, der den höheren Brechungsindex aufweist und in dem die Führung der Mode erfolgt, während die Mode in einem äußeren Bereich außerhalb dieses durch die beiden Übergänge eingeschlossenen inneren Bereiches evaneszent abklingt.

Dieser äußere Bereich weist einen geringeren Brechungsindex auf.

Bei einem graduellen Übergang des Brechungsindexes kann die Totalreflexion auch verteilt stattfinden, also jeweils nicht an einer definierbaren Ebene, sondern verteilt innerhalb eines Bereiches, der von Ebenen begrenzt wird.

Der jeweilige Übergang zwischen dem inneren und einem der beiden äußeren Bereiche ist durch eine kontinuierliche oder stufenweise Verringerung des Brechungsindex charakterisiert, so dass die Mode im höherbrechenden inneren Bereich geführt und in diesem Übergang zu einem äußeren Bereich geringeren Brechungsindexes totalreflektiert wird, wobei dieser Bereich des geringeren Brechungsindexes den äußeren Bereich darstellt, an dem die Mode evaneszent abklingt.

Die durch Totalreflexion gebildete Mode propagiert lateral.

Die Schichten der Schichtanordnungen sind bevorzugt hinsichtlich des transparenten Materials der Schichten (insbesondere also hinsichtlich Brechungsindex) und Dicke der jeweiligen Schicht (betrachtet in Schichtungsrichtung / Z-Richtung) so gewählt, z.B. durch vor der Herstellung des Wellenleiters vorgenommene Berechnung, dass in dem durch die Schichtanordnungen gebildeten Wellenleiter durch die Totalreflexion wenigstens eine Mode des vorbestimmten Wellenlängenbereiches oder der vorbestimmten Wellenlänge(n) lateral führbar ist, die in ihrer senkrecht zur Führungsrichtung, also in der Schichtungsrichtung bzw. Z-Richtung betrachteten Intensitätsverteilung wenigstens ein, bevorzugt genau ein lokales Intensitätsminimum aufweist, welches sich innerhalb der lichtablenkenden Struktur befindet (betrachtet in Schichtungsrichtung bzw. Z-Richtung), bevorzugt wobei sich die das lokale Minimum umgebenden lokalen Maxima der Intensitätsverteilung um die lichtablenkende Struktur herum, also außerhalb von dieser befinden, insbesondere in der jeweiligen Schichtanordnung befinden. Eine vorbestimmte Wellenlänge ist somit bevorzugt sowohl eine solche, für welche die lichtablenkende Struktur eine Ablenkung in den Wellenleiter vornimmt als auch eine solche, mit der eine geführte Mode mit zur lichtablenkenden Struktur passend positioniertem Intensitätsminimum im Wellenleiter erzeugt wird.

Bei einer konstruktiv aneinander angepassten Auswahl von Schichten des Wellenleiters und Position der lichtablenkenden Struktur im Wellenleiter kann die lichtablenkende Struktur also eingerichtet sein, aus dem einfallenden Licht der vorbestimmten Wellenlänge(n) eine im Wellenleiter propagierende Mode anzuregen, die in Z-Richtung betrachtet wenigstens ein lokales Intensitätsminimum hat, welches in der lichtablenkenden Struktur liegt und bevorzugt außen um die Struktur herum angeordnete lokale Intensitätsmaxima hat.

Hierdurch wird erreicht, dass der überwiegende Teil der Intensität der Mode außerhalb der lichtablenkenden Struktur im Wellenleiter geführt wird. Durch die lichtablenkende Struktur erzeugte Verluste werden somit minimiert. Eine derart angeordnete lichtablenkende Struktur kann somit dazu dienen, auf den Wellenleiter einfallendes Licht auf einer relativ großen Ausdehnung in Bezug auf die Propagationsrichtung der anzuregenden Mode in den Wellenleiter einzukoppeln, da diese anzuregende Mode infolge des geringen Überlaps mit der lichtablenkenden Struktur eine hohe Propagationslänge aufweist. Bevorzugt liegt das lokale Minimum der Intensität der geführten Mode in der Z-Richtung, bzw. der Schichtungsrichtung betrachtet innerhalb der lichtablenkenden Struktur.

Unter der Anordnung des lokalen Intensitätsminimums innerhalb der lichtablenkenden Struktur wird bevorzugt verstanden, dass bezogen auf die angenommene Z-Achse eines Koordinatensystems, die parallel zur Schichtungsrichtung liegt, sich das Intensitätsminimum an einer Koordinate $Z_{min}$ befindet, die im Koordinatenintervall liegt, über welches hinweg die lichtablenkende Struktur in der Richtung der Z-Achse erstreckt ist. Die Koordinaten $Z_{max1}$ und $Z_{max2}$ von zwei um das betrachtete lokale Minimum herum angeordneten Intensitätsmaxima liegen außerhalb dieses Intervalls. Erstreckt sich beispielsweise die lichtablenkende Struktur in der Z-Richtung in einem Koordinatenintervall von $Z_1$ bis $Z_2$, so gilt: $Z_{max1} < Z_1 < Z_{min} < Z_2 < Z_{max2}$.

In weiterhin bevorzugter Ausgestaltung der Erfindung kann der Wellenleiter hinsichtlich seiner Schichtanordnungen symmetrisch aufgebaut sein. Insbesondere wird darunter verstanden, dass die Schichten beider die lichtablenkende Struktur umgebenden Schichtanordnungen hinsichtlich einer Mittelebene, vorzugsweise um die herum ebenfalls die lichtablenkende Struktur angeordnet ist, hinsichtlich Dicke und Brechungsindex symmetrisch, insbesondere spiegelsymmetrisch aufgebaut sind.

Eine symmetrische Anordnung hat den Vorteil einer von der Wellenlänge weitgehend unabhängigen in Z-Richtung betrachteten Position des lokalen Minimums der Intensität einer Mode. Das Prinzip der Ablenkung und ModenErzeugung kann so für einen größeren Wellenlängenbereich erzielt werden im Vergleich zur nicht symmetrischen Anordnung.

Bei einem Lichtkonzentrator der eingangs genannten Publikation wird die lichtablenkende Struktur als eine nanostrukturierte Schicht beschrieben, deren Strukturen kleiner sind als die Wellenlänge einer im Wellenleiter geführten Mode. Die Ablenkung des Lichtes in den Wellenleiter hinein erfolgt daher z.B. durch Beugung, also eine Wechselwirkung höherer Ordnung, somit also mit verringerter Effizienz, da das Licht in nullter Ordnung keine Ablenkung in den Wellenleiter erfährt.

Aufgabe der Erfindung ist es, einen Lichtkonzentrator der eingangs genannten Art bereitzustellen, der eine vergrößerte Effizienz und verringerte Dispersion bezüglich der Einkopplung und Auskopplung erzielt, bevorzugt durch eine Lichtablenkung in nullter Ordnung, beispielsweise nach den Prinzipien der geometrischen Optik, z.B. mittels Reflektion oder Brechung. Dabei soll der Leistungsverlust durch Beugung an der lichtablenkenden Struktur signifikant reduziert werden.

Diese Aufgabe wird dadurch gelöst, dass die lichtablenkende Struktur einen Lichtlenker aufweist oder mehrere Lichtlenker aufweist, die senkrecht zur Schichtungsrichtung nebeneinander angeordnet sind, wobei ein jeweiliger Lichtlenker Facetten aufweist, insbesondere durch Bereiche unterschiedlicher Brechungsindizes gebildete Facetten aufweist, die jeweils in jeder von drei zueinander senkrechten Raumrichtungen größer als die größte Wellenlänge des vorbestimmten Wellenlängenbereiches ausgebildet sind und mit denen das einfallende Licht in Richtung zu einem dem jeweiligen Lichtlenker zugeordneten Lichtsammelbereich ablenkbar ist, wobei eine Facette durch eine Grenzfläche zwischen zwei dielektrischen Medien mit unterschiedlichem Brechungsindex gebildet ist, wobei an beiden Übergängen zwischen innerem Bereich und äußerem Bereich der Schichtanordnungen an denen die Totalreflexionen dadurch ermöglicht sind, dass am Übergang jeweils ein stufenweise oder räumlich verteilter Übergang vom höheren Brechungsindex im inneren Bereich zu einem um einen Brechungsindexunterschied reduzierten Brechungsindex im äußeren Bereich gegeben ist und wobei dieser Brechungsindexunterschied kleiner ist als $1\times10^{-3}$.

Hierdurch kann Licht von der lichtsammelnden Oberfläche der Struktur konzentriert werden.

Bevorzugt kann das Licht durch die Facetten weiterhin auch in Richtung zu einem Auskoppelelement ablenkbar sein, insbesondere welches nicht Teil der Lichtlenker ist, sondern vorzugsweise welches sich in Z-Richtung betrachtet versetzt, insbesondere oberhalb oder unterhalb des Lichtsammelbereiches und/oder Lichtlenkers befindet.

Erfindungsgemäß ist eine Facette durch eine Grenzfläche zwischen zwei dielektrischen Medien mit unterschiedlichem Brechungsindex gebildet. Weiter bevorzugt kann die Facette bzw. Grenzfläche in einer Schnittebene, welche die Z-Achse umfasst, vorzugsweise linear erstreckt ausgebildet sein, insbesondere aber auch gekrümmt ausgebildet sein.

Weiterhin ist es erfindungsgemäß vorgesehen, dass an beiden Übergängen zwischen innerem Bereich und äußerem Bereich, insbesondere die in Z-Richtung beidseits der Lichtlenker in den jeweiligen Schichtanordnungen angeordnet sind, an denen die Totalreflexionen stattfinden, jeweils ein stufenweiser oder räumlich verteilter Übergang vom höheren Brechungsindex im inneren Bereich zu einem um einen Brechungsindexunterschied reduzierten Brechungsindex im äußeren Bereich erfolgt und wobei dieser Brechungsindexunterschied kleiner ist als $1\times10^{-3}$, weiter bevorzugt kleiner ist als $1\times10^{-4}$, noch weiter bevorzugt kleiner $1\times10^{-5}$.

Beispielsweise kann bei jeder Schichtanordnung von Schichten des Wellenleiters, welche an einen Lichtlenker angrenzt, der Brechungsindex, insbesondere der über die Schichtdicke gemittelte Brechungsindex einer von dem Lichtlenker weiter entfernten Schicht geringer sein als der Brechungsindex einer näheren Schicht, wobei der Brechungsindexunterschied der benachbarten Schichten einer Schichtanordnung kleiner ist als $1\times10^{-3}$, weiter bevorzugt kleiner ist als $1\times10^{-4}$.

In allen Fällen kann bevorzugt der Brechungsindexunterschied kleiner sein als ein Wert $n_i - n_a$, welcher die

Bedingung $$M = 1 + int(2V/\pi) \text{ mit } V = 2\pi t_i n_i / \quad \lambda \sqrt{n_i^2 - n_a^2}$$ erfüllt, wobei $n_i$ der gemittelte Brechungsindex des inneren Bereiches und $n_a$ der gemittelte Brechungsindex des für die Wellenführung relevanten Teils des äußeren Bereiches ist, der also in Richtung $z$ nicht weiter als $t_i/2$ vom inneren Bereich entfernt ist, $\lambda$ die Wellenlänge und $t_i$ die Dicke des inneren Bereiches der Schichtanordnung ist.

Gegenüber dem zitierten Stand der Technik hat die Erfindung den Vorteil, dass aufgrund der Ausbildung der vorzugsweise durch Bereiche unterschiedlicher Brechungsindizes gebildeten Facetten eines Lichtlenkers, welche größer als die wenigstens eine vorbestimmte Wellenlänge sind, für diese wenigstens eine Wellenlänge eine Ablenkung und Modenerzeugung erfolgt, wobei die Ablenkung zumindest überwiegend auf den Prinzipien der geometrischen Optik beruht, also z.B. durch Reflexion oder Brechung. Eine Ablenkung in den Wellenleiter durch Beugung findet entweder nicht statt oder bildet zumindest nicht das überwiegende Ablenkungsprinzip, ist somit insbesondere als vernachlässigbar zu bezeichnen.

Durch die Ausbildung der Facetten, welche größer, vorzugsweise welche in drei zueinander senkrechten Raumrichtungen größer als die wenigstens eine vorbestimmte Wellenlänge sind, hat auch jeder Lichtlenker, insbesondere die gesamte lichtablenkende Struktur bevorzugt auch in der eingangs genannten Schichtungsrichtung, insbesondere der genannten Z-Richtung eines angenommenen Koordinatensystems eine Erstreckung, die größer als die vorbestimmte Wellenlänge ist. Die vorbestimmte Wellenlänge kann eine Wellenlänge eines Wellenlängenbereiches sein, der im Wellenleiter propagierbar ist, z.B. die mittlere Wellenlänge dieses Bereiches oder auch die maximale Wellenlänge dieses Bereiches.

Im Vergleich zum eingangs genannten Stand der Technik weist jede Facette eines Lichtlenkers und somit der lichtablenkenden Struktur eine makroskopische Ausbildung auf, insbesondere mit einer Größe in jeder der drei Raumrichtungen von n x λ, wobei λ der vorbestimmten Wellenlänge des Lichtes entspricht, wobei weiterhin gilt das $n \geq 1$ ist, vorzugsweise $n \geq 2$ ist, weiter bevorzugt $n \geq 3$ ist, noch weiter bevorzugt $n \geq 4$ ist, noch weiter bevorzugt $n \geq 10$.

In absoluten Maßen ergibt sich in der Schichtungsrichtung (Z-Richtung) und/oder in jeder der drei Raumrichtungen eine Größe einer Facette von mehr als 900 nm, weiter bevorzugt mehr als 1800 nm, noch weiter bevorzugt mehr als 2700 nm, noch weiter bevorzugt mehr als 3600 nm, noch weiter bevorzugt mehr als 9 Mikrometer.

Vorzugsweise kann die Dicke des Wellenleiters mit den beiden die lichtablenkende Struktur umgebenden Schichtanordnungen insgesamt größer sein als m x λ, wobei λ der vorbestimmten Wellenlänge des Lichtes entspricht und m>10 ist, vorzugsweise m > 20 ist, weiter vorzugsweise m > 100, weiter bevorzugt m > 200 ist.

Die Lichtlenker können grundsätzlich in einer Nebeneinanderanordnung ausgeführt sein. Bei einer solchen Anordnung von mehreren Lichtlenkern liegen diese in einer Ebene nebeneinander, die senkrecht liegt zur Schichtungsrichtung, die also parallel ist zur X-Y-Ebene eines kartesischen Koordinatensystems oder die parallel ist zu einer von ρ und φ aufgespannten Ebene eines Zylinderkoordinatensystems.

Durch die von einem Lichtlenker aus betrachtet in Schichtungsrichtung nach außen hin erfolgende Abnahme des Brechungsindexes in den Schichten der beiden Schichtanordnungen wird die Führung des Lichtes der geführten Mode im Wellenleiter durch das Prinzip der Totalreflexion bewirkt. Durch die geringen Unterschiede der Brechungsindizes benachbarter Schichten wird eine geringe Führung der Moden erzielt.

Hierdurch kann eine Reduktion der Anzahl möglicher Moden im Wellenleiter gegenüber dem genannten Stand der Technik erzielt werden. Insbesondere wird erzielt, dass trotz der großen Ausdehnung der lichtablenkenden Struktur in Schichtungsrichtung, insbesondere auch der Schichtanordnungen, und bevorzugt somit des gesamten Wellenleiters in der Z-Richtung im Vergleich zum Stand der Technik nicht die Anzahl der geführten Moden vergrößert wird. Es kann so im Vergleich zum Stand der Technik ein vergrößertes Intensitätsprofil in der Z-Richtung erzeugt werden, dessen Intensitätsminimum den Überlapp der Mode mit der lichtablenkenden Struktur wirksam minimiert, insbesondere unter Einhaltung der nachfolgend genannten Intensitätsbedingungen.

Die genannten geringen Unterschiede der Brechungsindizes benachbarter Schichten einer Schichtanordnung bzw. zwischen dem inneren Bereich und dem äußeren Bereich der Schichtanordnungen, können in bevorzugter Ausführung erreicht werden durch unterschiedliche Dotierung desselben Wirtsmaterials, insbesondere Polymers, aus welchem eine jeweilige Schicht der Schichtanordnung bzw. der beiden Bereiche ausgebildet ist.

Unter einer Schichtanordnung von wenigstens zwei Schichten wird nicht nur verstanden, dass die wenigstens zwei Schichten über eine diskrete Grenzschicht aneinander angrenzen, an der ein sprunghafter Materialwechsel und/oder Brechungsindexwechsel stattfindet, sondern es werden darunter auch wenigstens zwei senkrecht zur Schichtungsrichtung in der Ebene erstreckte Materialbereiche von unterschiedlichem Material und/oder unterschiedlichem Brechungsindex verstanden, zwischen denen es einen in der Schichtungsrichtung erstreckten Grenzbereich gibt, in welchem sich das Material und/oder der Brechungsindex stetig ändert.

Trotz derart großer Ausbildung können die Facetten jedes Lichtlenkers in einer Richtung senkrecht zur Schichtungsrichtung und damit in einer Richtung parallel zur Propagationsrichtung wenigstens einer geführten Mode, bzw. lateral hintereinander liegen und einfallendes Licht jeweils in den Wellenleiter einkoppeln, ohne dass eine Abschattung durch andere im Propagationsweg der Mode liegende Facetten signifikant ist, weil die lichtablenkende Struktur und damit auch jeder Lichtlenker und damit jede Facette erfindungsgemäß im lokalen Intensitätsminimum der erzeugten geführten Mode liegt, denn die Position, insbesondere Z-Position, der lichtablenkenden Struktur / des Lichtlenkers ist durch die konstruktive Einrichtung des Wellenleiters so gelegt, dass sie für die vorbestimmte(n) Wellenlänge(n) in der Schichtungsrichtung oder Z-Richtung auf der lichtablenkenden Struktur / dem Lichtlenker zu liegen kommt. Die üblichen Abschattungsprobleme der geometrischen Optik sind somit durch die Erfindung umgangen.

In bevorzugter Ausführung weist die lichtablenkende Struktur und somit der Lichtlenker bzw. jeder Lichtlenker und jede Schichtanordnung eine Erstreckung in der Schichtungsrichtung bzw. Z-Richtung des Wellenleiters auf, so dass die lichtablenkende Struktur / der Lichtlenker in Bereichen kleiner als $I_{max}$/m liegt bezogen auf ein neben dem lokalen Minimum liegendes lokales Maximum $I_{max}$ der Intensität mit m größer 10, bevorzugt m größer 50, weiter bevorzugt m größer 100, noch weiter bevorzugt m größer 250, noch weiter bevorzugt m größer 1000.

Die wenigstens eine vorbestimmte Wellenlänge liegt bevorzugt im Bereich von 300 bis 2500 nm und somit im Sonnenlichtspektrum, weiter bevorzugt im Bereich von 400 bis 900 nm. Dieser Wellenlängenbereich bildet somit bevorzugt den eingangs auch genannten vorbestimmten Wellenlängenbereich. So kann die erfindungsgemäße Vorrichtung in bevorzugter Anwendung zur Konzentrierung von Sonnenlicht, z.B. auf eine Solarzelle verwendet werden.

Der Lichtlenker muss nicht aus einer Ansammlung von Festkörper-Material bestehen, wenngleich er ein solches umfassen oder aus einem solchen Material bestehen kann.

Insbesondere soll der Begriff auch umfassen, dass der Lichtlenker die Anordnung eines Mediums darstellt, wobei das Medium auch eine Flüssigkeit, ein Gas oder Gasgemisch oder auch Vakuum sein kann. Ein Lichtlenker kann somit auch durch einen Körper oder mehrere Körper im Wellenleiter, insbesondere in wenigstens einer der inneren Schichten ausgebildet sein, der/die aus einem beliebigen Medium bestehen oder auch ungefüllt (evakuiert) sein kann/-

können. Mögliche Festkörper-Materialien für einen Lichtlenker sind transparente Oxide, Nitride, Salze, sonstige anorganische oder organische Verbindungen, transparente Polymere und andere transparente Materialen. Ein Medium kann auch durch ein Gas oder Gasgemisch gebildet werden.

Vorzugsweise werden als die inneren Schichten, bzw. als der innere Bereich des Wellenleiters dabei die Schichten verstanden, die direkt angrenzend an die Lichtlenker angeordnet sind, bzw. diese umfassen. Die Schichten des äußeren Bereichs liegen außen darum herum. Vorzugsweise ist die Grenze zwischen innerem und äußeren Bereich durch die Orte bestimmt, an denen Licht der im Wellenleiter propagierenden Mode durch Totalreflexion geführt ist.

Insgesamt ermöglicht es somit die erfindungsgemäße Ausgestaltung eines Lichtkonzentrators auf den Wellenleiter einfallendes Licht durch Wechselwirkung mit der lichtablenkenden Struktur bzw. einem Lichtlenker in überwiegend nullter Ordnung, insbesondere also z.B. durch Reflexion, Brechung in den Wellenleiter einzukoppeln und in Richtung zum Lichtsammelbereich zu konzentrieren, wobei die lichtablenkende Struktur bzw. der Lichtlenker sich im Minimum der wenigstens einen, insbesondere genau einen geführten Mode oder bei mehreren geführten Moden pro (vorbestimmter) Wellenlänge sich im Intensitätsminimum aller geführten Moden befindet bzw. umgekehrt betrachtet das Intensitätsminimum einer jeweiligen geführten Mode bezüglich der Z-Richtung innerhalb der lichtablenkenden Struktur oder dem Lichtlenker liegt.

Dabei ist zu berücksichtigen, dass nicht die Existenz der lichtablenkenden Struktur oder des Lichtlenkers die Positionierung des Intensitätsminimums oder der Intensitätsminima einer geführten Mode bedingt, sondern dass die Position des Intensitätsminimums oder der Intensitätsminima einer geführten Mode bestimmt ist, insbesondere zumindest hauptsächlich bestimmt ist von den in der Schichtungsrichtung übereinanderliegenden Schichten der beiden die lichtablenkende Struktur / den Lichtlenker umgebenden Schichtanordnungen. Wenn überhaupt, so wird die Position durch die lichtablenkende Struktur / den Lichtlenker allenfalls geringfügig beeinflusst.

Die Lage der lichtablenkenden Struktur / des Lichtlenkers und des wenigstens einen Intensitätsminimums lässt sich somit zuvor bestimmen, z.B. durch Berechnung, insbesondere in Abhängigkeit von zumindest den Schichtparametern (z.B. Brechungsindex, Dicke) und der Wellenleiter so fertigen, dass das Intensitätsminimum der wenigstens einen geführte Mode erfindungsgemäß auf der lichtablenkenden Struktur oder auf dem Lichtlenker liegt.

Der Lichtsammelbereich ist ein in X- und Y- Richtung betrachtet beschränkter, vorzugsweise flächig beschränkter Bereich des Lichtlenkers auf den zu die im Wellenleiter geführte Mode propagiert, insbesondere zumindest aus einer Richtung, vorzugsweise aus mehreren Richtungen. Besonders bevorzugt propagiert die geführte Mode im Wellenleiter aus zumindest zwei einander entgegengesetzten Richtungen zum Lichtsammelbereich, vorzugsweise aus einer Vielzahl von einander entgegengesetzten Richtungen. Damit ist der Lichtsammelbereich derjenige Bereich des Lichtlenkers mit der höchsten Intensität obgleich dieser räumlich mit der Position des in Z-Richtung betrachteten Intensitätsminimums zusammenfällt während das Intensitätsmaximum der geführten Mode gegenüber dem Lichtlenker in Z-Richtung betrachtet versetzt ist. Vorzugsweise ist der Lichtsammelbereich ein Bereich des Lichtlenkers um welchen die Facetten des Lichtlenkers herum angeordnet sind.

Der Lichtsammelbereich kann z.B. durch einen Bereich, insbesondere durch einen in radialer Richtung um die Z-Achse herum beschränkten Bereich, insbesondere des Lichtlenkers ausgebildet sein, um den herum die Facetten des Lichtlenkers angeordnet sind.

Vorzugsweise kann ein Auskoppelelement im Wellenleiter vorgesehen sein, mit dem Licht in Richtung zu einer zu beleuchtenden Anordnung abgelenkt werden kann, z.B. in Richtung zu einer zu beleuchtenden Anordnung, insbesondere zu einer Solarzelle, die im Wellenleiter oder in Z-Richtung benachbart zum Wellenleiter angeordnet ist.

Vorzugsweise liegt das Auskoppelelement in Z-Richtung betrachtet oberhalb oder unterhalb des Lichtsammelbereiches und/oder Lichtlenkers, insbesondere bildet es aber keinen Teil der lichtablenkenden Struktur / des Lichtlenkers, sondern ist von dieser unabhängig. Weiter bevorzugt ist das Auskoppelelementum die Z-Achse herum angeordnet, insbesondere wenn mit den Facetten eine Propagation der Mode aus mehreren Richtungen zur Z-Achse bewirkt wird.

Eine bevorzugte Weiterbildung der Erfindung kann es vorsehen, dass in Schichtungsrichtung unterhalb oder oberhalb des Auskoppelelements eine Solarzelle in einer Schicht oder auf der Oberfläche einer Schicht des Wellenleiters angeordnet ist, die durch aus dem Auskoppelelement austretendes, insbesondere gestreutes oder reflektiertes Licht beleuchtet ist.

Es besteht so die Möglichkeit das konzentrierte Licht in der Anordnung zu nutzen, z.B. mittels der Solarzelle in elektrische Energie zu konvertieren. Hierbei kann in Schichtungsrichtung auf der von der Anordnung / Solarzelle abgewandten Seite der lichtablenkenden Struktur eine Verspiegelung in einer Schicht oder auf der Oberfläche einer Schicht des wenigstens einen Wellenleiters angeordnet sein, insbesondere die in Richtung zur Anordnung / Solarzelle konkav ausgebildet ist. So kann nicht direkt zur Anordnung / Solarzelle gestreutes Licht mittels der Verspiegelung in Richtung zur Anordnung / Solarzelle reflektiert werden.

Das Auskoppelelement kann beispielsweise als eine Materialausnehmung in der lichtablenkenden Struktur und/oder wenigstens einer der Wellenleiterschichten ausgebildet sein. Eine solche Materialausnehmung kann vorzugsweise gasgefüllt oder evakuiert ausgeführt sein. So wird gewährleistet, dass das Auskoppelelement auch bei hohen Intensitäten nicht beschädigt wird.

Das Auskoppelelement kann insbesondere eine reflektierende, vorzugsweise totalreflektierende Anordnung, insbesondere von Grenzflächen zwischen verschiedenen Materialien und /oder Brechungsindizes, umfassen, mit der Licht aus der Richtung einer im Wellenleiter propagierenden Mode ablenkbar ist. Die Ablenkung kann bevorzugt in Richtung zu einer vorgenannten Solarzelle erfolgen.

Eine bevorzugte Ausführung kann es hier vorsehen, dass das Auskoppelelement in der Schichtungsrichtung betrachtet über oder unter dem Lichtlenker am Ort wenigstens eines der das lokale Intensitätsminimum umgebenden Intensitätsmaxima angeordnet ist. Hierdurch ist das Auskoppelelement in der Schichtungsrichtung versetzt zur lichtablenkenden Struktur bzw. dem Lichtlenker angeordnet, insbesondere versetzt um den Abstand zwischen dem Intensitätsminimum und einem benachbarten Intensitätsmaximum der geführten Mode. In Propagationsrichtung der Mode betrachtet liegt somit ein Intensitätsmaximum der Mode auf dem Auskoppelelement

Grundsätzlich kann es die Erfindung vorsehen, dass die Facetten eines Lichtlenkers nur in zwei einander entgegengesetzten Richtungen, also um 180 Grad um einen streifenförmigen Lichtsammelbereich herum angeordnet sind. Somit wird das Licht auf einen streifenförmigen Bereich hin konzentriert, eine Konzentration erfolgt also innerhalb des Wellenleiters nur in einer Dimension.

Eine bevorzugte Ausführung hingegen sieht es vor, dass jede Facette eines Lichtlenkers der lichtablenkenden Struktur den Lichtsammelbereich zumindest teilrahmenförmig, bevorzugt einen geschlossenen Rahmen ausbildend, weiter bevorzugt zumindest teilringförmig, insbesondere einen geschlossenen Ring ausbildend umgibt. So wird sichergestellt, dass auf den Wellenleiter einfallendes Licht aus mehreren Orten, die einen Lichtsammelbereich umgeben, vorzugsweise rahmenförmig oder ringförmig umgeben mit einer jeweiligen Facette in Richtung zu diesem Lichtsammelbereich abgelenkt wird. Somit wird das Licht auf einen kreisförmigen Lichtsammelbereich geführt und entsprechend innerhalb des Wellenleiters in zwei Dimensionen fokussiert.

Der Lichtsammelbereich kann für eine solche Ausführung als der Bereich des Lichtlenkers definiert werden, der sich innerhalb eines maximalen Abstandes $\rho_0$ vom geometrischen Mittelpunkt des jeweiligen Lichtlenkers befindet.

Jeder Lichtlenker kann, insbesondere zur Erzeugung einer reflektiven Ablenkung in nullter Ordnung, wenigstens eine reflektierende oder totalreflektierende Facette, vorzugsweise mehrere senkrecht zur Z-Richtung oder parallel zur mittleren Propagationsrichtung der Mode hintereinanderliegende reflektierende oder totalreflektierende Facetten aufweisen.

Z.B. kann eine jeweilige Facette bei (total-)reflektierender Ausbildung eine aus der X-Y-Ebene heraus in Richtung zur Z-Achse oder zu einem gedachten Zylinder um die Z-Achse geneigte Fläche bilden.

Zur Bildung einer Ablenkung durch Lichtbrechung in Transmission kann jeder Lichtlenker wenigstens eine Gruppe vorzugsweise mehrere Gruppen von wenigstens zwei zusammenwirkenden Facetten aufweisen, an denen transmittiertes Licht jeweils gebrochen wird, um insgesamt die Ablenkung auszuführen. Eine Facette kann jeweils durch eine Grenzfläche zwischen zwei Medien unterschiedlicher Brechungsindizes gebildet sein.

Eine besonders bevorzugte konstruktive Ausgestaltung der Erfindung sieht es vor, dass ein jeweiliger Lichtlenker einer lichtablenkenden Struktur bei einem angenommenen Ursprung eines Zylinderkoordinatensystems im Mittelpunkt des Lichtsammelbereichs und/oder im Zentrum des Lichtlenkers wenigstens eine, vorzugsweise mehrere senkrecht zur Z-Richtung oder parallel zur mittleren Propagationsrichtung der Mode hintereinanderliegende, die Z-Achse zumindest bereichsweise umgebende, vorzugsweise in Umfangsrichtung umgebende reflektierende oder Licht brechende Facetten aufweist. Bevorzugt ist es dabei weiterhin vorgesehen, dass der in die $\rho$-$\varphi$ Ebene projizierte Normalenvektor für jeden Ort auf jeder Facette des Lichtlenkers, ausgenommen ihres Randes, eine $\varphi$-Komponente von null aufweist. Das bedeutet, dass die Projektion des Normalenvektor jeder Facette entweder genau auf diesem Mittelpunkt hinweist oder genau davon weg, so dass der mit -1 multiplizierte Vektor genau auf den Mittelpunkt hinweist.

Die Facetten eines Lichtlenkers einer lichtablenkenden Struktur (alle oder zumindest einige von diesen, vorzugsweise zumindest die nahe zum Mittelpunkt gelegenen) können in weiter bevorzugter Ausführung um einen Mittelpunkt im Lichtsammelbereich bzw. um die Z-Achse herum rotationssymmetrisch ausgebildet sein.

Für jeden Ort auf einer Facette eines Lichtlenkers mit demselben radialen Abstand $\rho$ von der Z-Achse bei jedem beliebigen Winkel $\varphi$ ist somit der Wert von dessen Koordinate $Z(\rho,\varphi)$ gleich.

Reflektiv oder brechend abgelenktes senkrecht eingefallenes Licht wird hierdurch bezüglich $\varphi$ immer exakt zum Lichtsammelbereich abgelenkt.

Eine mögliche Ausführung kann es vorsehen, dass die reflektierende oder Licht brechende Facette eines Lichtlenkers betrachtet in einer Schnittebene, welche die Z-Achse umfasst, eine mit zunehmendem radialen Abstand $\rho$ von der Z-Achse im Z-Wert ansteigende Stufe ausbildet. Die Fläche einer solchen Stufe kann z.B. mit konstanter Steigung linear ansteigend ausgeführt sein. Dieser Steigungswinkel, bezeichnet als $\alpha$, wird vorzugsweise so gewählt, dass die Anregung der gewünschten Mode mit dem gewünschten Knoten durch senkrecht einfallendes Licht der gewünschten Wellenlänge bzw. des gewünschten Wellenlängenbereiches erzielt wird. Weiter bevorzugt kann die Stufe am radial außen liegenden Stufenende auf die radial innenliegende Stufenhöhe abfallen. Die radial innenliegende Stufenhöhe und die radial außen liegende Stufenhöhe jeder Stufe können bei allen Stufen vorzugsweise gleich sein, insbesondere also identische Z-Position haben.

Eine Ausführung kann es auch vorsehen, dass mit zunehmendem radialen Abstand ρ von der Z-Achse die in Z-Richtung betrachtete Höhe und/oder radiale Breite der Stufe einer Facette zunimmt. Dies ist insbesondere vorteilhaft, wenn das auf den Wellenleiter einfallende Licht ein über die Wellenleiterfläche konstantes Intensitätsprofil aufweist, wie es z.B. bei Sonnenlicht der Fall ist.

Eine jeweiliger Lichtlenker kann bei einer Projektion in Z-Richtung betrachtet vorzugsweise hinsichtlich seines radial äußeren, den Lichtlenker begrenzenden Randes kreisförmig ausgebildet sein, bevorzugt wobei die zumindest teilringförmigen Facetten und der äußeren Rand des Lichtlenkers konzentrisch zum Lichtsammelbereich angeordnet sind.

Allgemein kann der Wellenleiter mehrere Lichtlenker in einer Nebeneinanderanordnung in der X-Y Ebene oder parallel zu dieser aufweisen. Bei einer jeweils kreisförmigen Berandung der Lichtlenker wäre eine solche in einer Ebene vorgesehene Nebeneinanderanordnung mit einer nicht optimalen Flächenfüllung von Lichtlenkern und damit einer nicht optimalen Effizienz des erfindungsgemäßen Lichtkonzentrators verbunden.

Ein jeweiliger Lichtlenker kann z.B. bei einer Projektion in Z-Richtung betrachtet hinsichtlich seines äußeren Randes um einen jeweiligen Lichtsammelbereich mehreckig, bevorzugt rechteckig, weiter bevorzugt quadratisch ausgebildet sein.

Eine Weiterbildung, insbesondere des mehreckigen, bevorzugt rechteckigen, weiter bevorzugt quadratischen Randes eines Lichtlenkers aber auch der anderen Ausführungen kann es vorsehen, dass mehrere Lichtlenker in einer Ebene, insbesondere einer parallel zur X-Y-Ebene angeordneten Ebene kontaktierend nebeneinander also abstandslos angeordnet sind.

In einer möglichen Ausführung kann es vorgesehen sein, dass die Stufenhöhe wenigstens einer, bevorzugt aller Stufen oder Facetten eines Lichtlenkers in Umfangsrichtung um die Z-Achse variiert. Dies kann vorzugsweise bei einer nicht kreisförmigen Berandung eines Lichtlenkers erfolgen. Insbesondere kann bei einem Lichtlenker mit mehreckigem äußeren Rand die Stufenhöhe abhängig von der durch φ vorgegebenen Entfernung zwischen der Mittelachse des entsprechenden Lichtlenkers und des in Z-Richtung projizierten Randes des Lichtlenkers variieren. Dies hat den Vorteil, dass jedem Winkel φ ein zur Lichtsammlung optimales Profil $Z(\rho,\varphi)$ zugeordnet werden kann, das eine optimale Propagationslänge der angeregten Mode bewerkstelligt. Da beispielsweise die Diagonale eines Quadrats um die Wurzel von zwei länger ist als die Seitenlänge, benötigt eine in der entsprechenden Richtung propagierende Mode für einen insgesamt rechteckig oder quadratisch berandeten Lichtlenker kleinere Stufenhöhen, um eine höhere Propagationslänge zu erreichen.

Die Erfindung kann vorsehen, dass die gesamte von der in Projektion parallel zur Z-Achse betrachtete, durch den äußeren Rand einer Nebeneinanderanordnung von Lichtlenkern umgrenzte Fläche zur in derselben Richtung betrachteten Gesamtfläche der jeweiligen Lichtsammelbereiche ein Verhältnis bildet von V:1 mit V größer gleich 100.

Eine mögliche Ausführung kann es vorsehen, dass jeder Lichtlenker aus einem, vorzugsweise zusammenhängenden, transparenten dielektrischen Medium ausgebildet ist und die Licht reflektierenden oder brechenden Facetten des Lichtlenkers durch Grenzflächen zwischen dem Lichtlenker und dem daran angrenzenden Material des Wellenleiters ausgebildet sind. Besonders in dieser Ausführung kann zur Ausbildung einer total reflektierenden Facette des Lichtlenkers das Medium des Lichtlenkers einen Brechungsindex aufweisen, der kleiner ist als bei dem angrenzenden Material des Wellenleiters. Bei einer Licht brechenden Grenzfläche kann das Medium des Lichtlenkers einen Brechungsindex aufweisen, der größer aber auch kleiner ist als bei dem angrenzenden Material des Wellenleiters.

Insbesondere kann ganz allgemein das angrenzende Material ein zwischen dem Lichtlenker und einer planaren Schicht des Wellenleiters eingefügtes Material sein.

Wie eingangs erwähnt, kann ein erfindungsgemäßer Lichtkonzentrator auch aus einem in Z-Richtung angeordneten Stapel von mehreren Wellenleitern der vorbeschriebenen Art aufgebaut sein. Hier kann es vorgesehen sein, dass in einem Stapel von wenigstens zwei, vorzugsweise symmetrischen Wellenleitern, die jeweils eine lichtablenkende Struktur umfassen, die in Stapelungsrichtung sich zumindest bereichsweise überdeckenden lichtablenkenden Strukturen verschiedener Wellenleiter zueinander senkrecht zur Stapelungsrichtung versetzte Lichtsammelbereiche aufweisen. Dafür können die Wellenleiter insgesamt zueinander lateral versetzt sein.

Eine solche Ausbildung ist besonders dann vorteilhaft, wenn in einem Stapel von wenigstens zwei vorzugsweise symmetrischen Wellenleitern jeder Wellenleiter mit seiner lichtablenkenden Struktur eingerichtet ist, aus dem Gesamtwellenlängenspektrum von auf den Stapel insgesamt einfallendem Licht einen jeweils anderen vorbestimmten Teil-Spektralbereich auf den Lichtsammelbereich abzulenken. Es können dann weiter bevorzugt die in einem jeweiligen Wellenleiter oder am Lichtkonzentrator angrenzenden angeordneten Solarzellen für den Teil-Spektralbereich effizienzoptimiert ausgebildet sein. Es kann so dem Umstand Rechnung getragen werden, dass mit einer Solarzelle nicht über das gesamte Sonnenlichtspektrum hinweg mit gleichbleibender Effizienz eine Wandlung des Lichtes in nutzbare elektrische Energie möglich ist.

Eine konkrete Einrichtung eines Wellenleiters kann durch eine Anpassung des durch die Stufenhöhe und Stufenbreite bestimmten Steigungswinkels der Facetten des Lichtlenkers der jeweiligen lichtablenkenden Struktur sowie der verbleibenden geometrischen und dielektrischen Parameter (Brechungsindex, Dicke,..) der Wellenleiter an den zu sammelnden Teilspektralbereich erfolgen. Hierbei kann durch numerische Simulation des Wellenleiters eine Vorhersage des beim Lichtsammelbereich ankommenden Teil-Spektralbereiches des geführten Lichtes getroffen werden. Durch Variation des Steigungswinkels der jeweiligen Facetten eines Lichtlenkers und der geometrischen und dielektrischen Parameter des verbleibenden Wellenleiters wird der simulierte beim Lichtsammelbereich ankommende Teil-Spektralbereich an den gewünschten Spektralbereich angeglichen. Die so optimierten Wellenleiter können als Fertigungsvorlage verwendet werden.

Ein Lichtkonzentrator der Erfindung kann in möglicher Ausbildung mit kontaktierend in der X-Y-Ebene nebeneinander angeordneten Lichtlenkern in jeder senkrecht zur Schichtungsrichtung liegenden Richtung jeweils Abmessungen von mindestens 10 cm aufweisen.

Bei der Herstellung eines Lichtkonzentrators kann es vorgesehen sein, dass die Schichten des Wellenleiters durch aufeinander laminierte Polymerfilme gebildet sind.

Ein jeweiliger Lichtlenker kann allgemein durch einen Hohlraum oder mehrere separierte Hohlräume in wenigstens einer der Schichten einer Schichtanordnung, insbesondere eines Polymerfilms ausgebildet sein. Ein solcher Hohlraum kann z.B. durch Abformung eines Reliefs und anschließender Auffüllung durch ein dielektrisches Material realisiert sein. Wenigstens eine Grenzfläche eines solchen Hohlraums zum benachbarten Medium kann eine Facette des Lichtlenkers bilden.

Die Erfindung wird anhand der nachfolgenden Figuren näher erläutert:

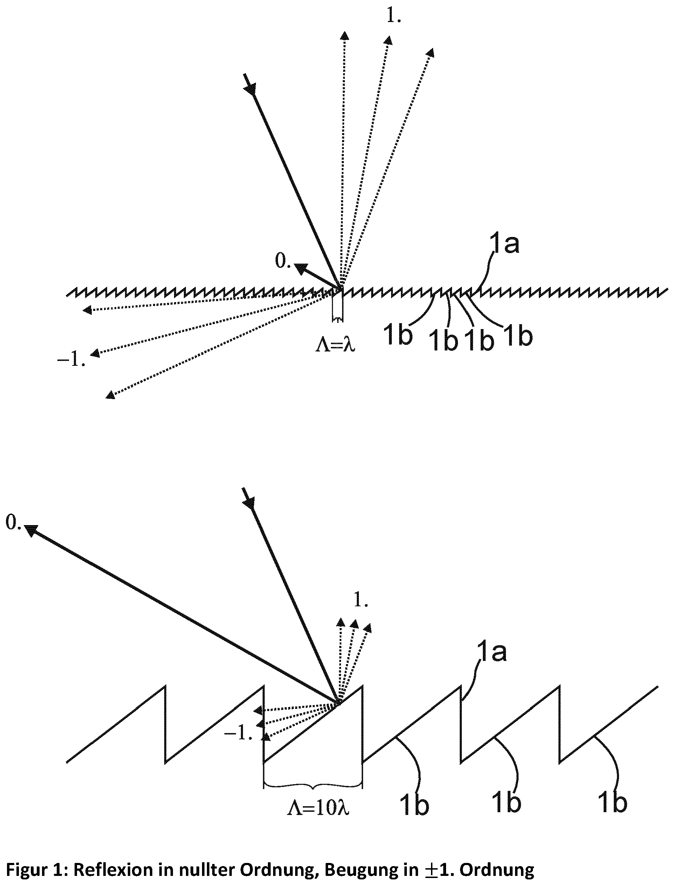

Die Figur 1 zeigt schematisch einen Lichtlenker 1a auf welchen Licht einfällt. Die obere Abbildung verdeutlicht, dass bei einer Ausdehnung $\Lambda$ der Facetten 1b des Lichtlenkers 1a in der Größenordnung der Wellenlänge $\lambda$ des einfallenden Lichtes Beugungseffekte die Wechselwirkung zwischen Licht und der Struktur dominieren. Dabei ist die Ablenkung durch Beugung aufgrund von Dispersion von der Wellenlänge abhängig. Während also der breitbandig einfallende Strahl in nullter Ordnung breitbandig reflektiert wird (ein Pfeil) propagieren die in 1. oder -1. Richtung gebeugten Strahlen unterschiedlicher Farbe in verschiedene Richtungen (visualisiert durch jeweils drei gestrichelte Pfeile).

Ist hingegen gemäß der unteren Abbildung die Ausdehnung $\Lambda$ der Facetten 1b des Lichtlenkers 1a größer als die Wellenlänge, hier im Beispiel 10x größer als die Wellenlänge $\lambda$ des einfallenden Lichtes, so dominiert die Wechselwirkung nullter Ordnung, also z.B. die Reflektion. Die anteilige Wechselwirkung durch Beugung ist untergeordneter Art, was durch die verhältnismäßige Länge der Pfeile visualisiert wird. Dispersive Effekte werden weitgehend vermieden. Die Erfindung macht es sich zunutze durch eine lichtablenkende Struktur zwischen den Schichtanordnungen eines Wellenleiters eine Lichtablenkung in überwiegend nullter Ordnung, also z.B. durch Reflektion oder Beugung zu erzeugen, wodurch sich eine effiziente wellenlängenunabhängige Ablenkung erzielen lässt.

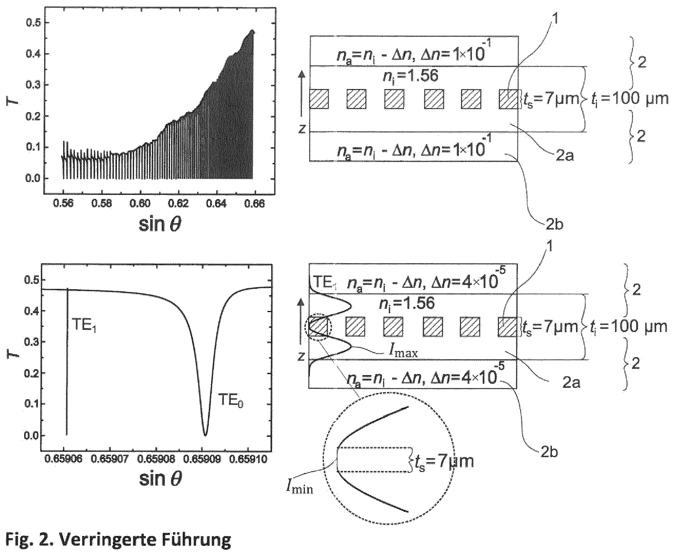

Die Figur 2 zeigt den schematischen Aufbau eines Wellenleiters mit einer lichtablenkenden Struktur 1 die zwischen zwei Schichtanordnungen 2 eingebettet ist. Gezeigt ist ein 100$\mu$m dicker innerer Bereich (2a,1,2a) des Wellenleiters mit Gitterkoppler.

Die obere Darstellung verdeutlicht, dass sich bei einem Brechungsindexunterschied von 1x $10^{-1}$ zwischen den Schichten 2a und 2b einer Schichtanordnung 2 eine Vielzahl von möglichen im Wellenleiter führbaren Moden ergibt, was durch die berechnete Anzahl der Transmissionsminima verdeutlicht ist.

Demgegenüber ist in der unteren Darstellung ersichtlich, dass bei einem vergleichsweise geringen Brechungsindexunterschied von in diesem Beispiel 4x$10^{-5}$ sich nur zwei im Wellenleiter führbaren Moden ergeben. Die berechnete $TE_1$-Mode weist in Z-Richtung ein Intensitätsprofil auf, dessen lokales Minimum $I_{min}$ mit der lichtablenkenden Struktur 1 räumlich zusammenfällt. Die deutlich höhere Propagationslänge dieser Mode im Vergleich zu $TE_1$ ist an der viel schmaleren Resonanz zu erkennen.

So verdeutlicht die Berechnung, dass selbst mit großen Schichtdicken, die deutlich größer sind als die Wellenlänge des einfallenden und geführten Lichtes sich singuläre Moden im Wellenleiter führen lassen, deren Intensitätsminimum bezüglich z auf der lichtablenkenden Struktur 1 liegen.

Die Lösung zum Erreichen einer verringerten Wechselwirkung zwischen der geführten Mode und der lichtablenkenden Struktur 1 besteht somit in der Verringerung des Brechungsindexunterschiedes $\Delta n$ zwischen den Materialien an der die Totalreflexion verursachenden Grenzfläche. In dieser Simulation ist eine stufenweise Variation des Brechungsindex an einer festen Grenzfläche angenommen. Tatsächlich kann eine zum Beispiel durch Dotierung verursachte Veränderung des Brechungsindex auch stetig über eine gewisse Ausdehnung $\Delta z$ in Richtung z hinweg erzeugt werden, so dass die Totalreflexion nicht mehr an einer fest lokalisierbaren Grenzfläche bei konstantem z erfolgt, sondern verteilt im Bereich $\Delta z$, in dem der Index von innen nach außen graduell um $\Delta n$ verringert wird. In dem Fall geht zwar der Stufenwellenleiter in einen Gradientenwellenleiter über, die wesentliche Aussage bleibt aber erhalten, dass mit abnehmendem $\Delta n$ bei gleicher Dicke des inneren Bereiches des Wellenleiters die Zahl der Moden im Wellenleiter ebenfalls abnimmt.

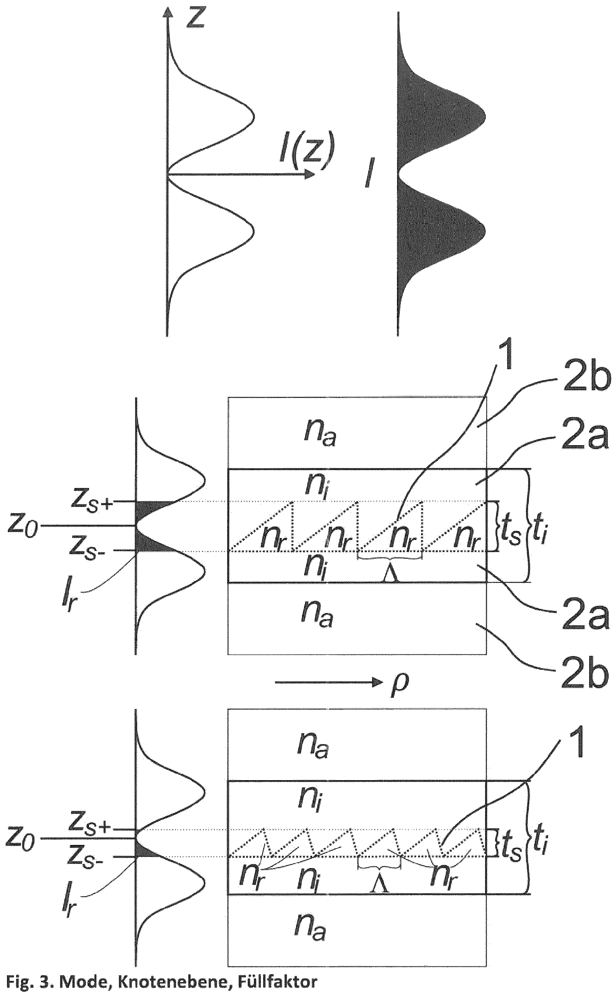

Die Figur 3 zeigt eine innerhalb des inneren Bereiches mit $n_i > n_a$ geführte Mode, die eine für sie spezifische Intensitätsverteilung $I(z)$ hat. Die Struktur 1 und die an die Struktur 1 angrenzenden Schichten der beidseits um die lichtablenkende Struktur angeordneten Schichtanordnungen 2 bilden gemeinsam den inneren Bereich 2a des Wellenleiters.

Gezeigt ist $I(z)$ einer durch die lichtablenkende Struktur weitgehend ungestörten (z. B. durch $n_r \approx n_i$) $TE_1$ Mode, die im äußeren Bereich mit $n_a$ exponentiell abfällt und im inneren Bereich ein näherungsweise sinusförmige Feldverteilung $E(z)$ mit einer Nullstelle bei $z_0$ aufweist. Diese Nullstelle ist auch in der Intensitätsverteilung $I(z) \sim E(z)$ vorhanden und wird als Knoten bezeichnet. Für alle $x, y$ (kartesisch) und entsprechend für alle $\rho, \varphi$ (Zylinderkoordinaten) verschwindet bei $z = z_0$ die Mode. Die entsprechende Ebene wird daher als Knotenebene bezeichnet. Die Struktur 1 liegt nun mit einer Dicke bzw. Ausdehnung $t_s$ in Richtung z innerhalb der die Mode führenden Schicht mit $n_i$ der Dicke $t_i$, wobei entsprechend $t_s < t_i$ gelten muss. Die Ausdehnung der lichtablenkenden Struktur 1 erstreckt sich auf der z-Achse im gesamten Bereich $z_{s-} < z \leq z_{s+}$. Der Füllfaktor F gibt den Anteil der Mode an, die innerhalb der lichtablenkenden Struktur 1 geführt wird:

$$F = \int_{z_{s-}}^{z_{s+}} I(z) \Big/ \int_{-\infty}^{\infty} I(z)$$ . Ziel ist es, diesen Füllfaktor der Mode innerhalb der lichtablenkenden Struktur 1 möglichst stark zu verringern. Zu diesem Zweck ist es besonders wünschenswert, dass die Knotenebene innerhalb der lichtablenkenden Struktur 1 liegt ($z_{s-} < z_0 \leq z_{s+}$) oder wenigstens in ihrer Nähe ($z_0 - z_{s+} < t_i$ oder $z_{s-} - z_0 < t_i$).

In bevorzugter Ausführung ist es vorgesehen, dass der Füllfaktor F der Mode kleiner ist als $10^{-3}$, besonders bevorzugt kleiner ist als $10^{-5}$.

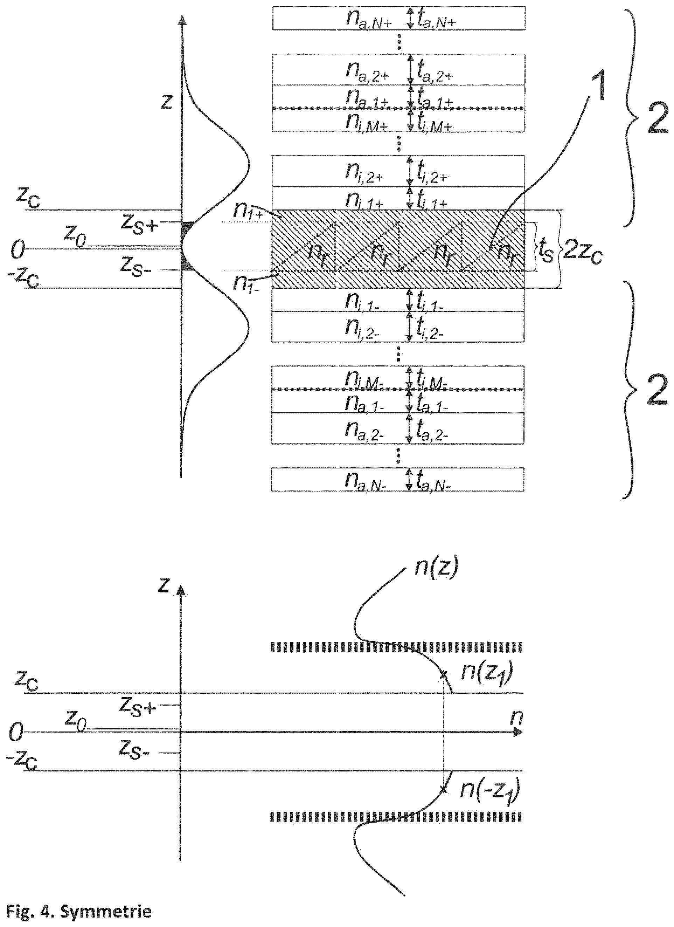

Die Figur 4 visualisiert eine bevorzugte Ausführung der Erfindung, bei welcher ein für $|z| \geq z_c$ symmetrischer Schichtaufbau des Wellenleiters eines erfindungsgemäßen Lichtkonzentrators vorliegt.

Damit die Knotenposition einer $TE_1$-Mode oder einer $TM_1$-Mode unabhängig von der Wellenlänge immer bei $z_0$ liegt, ist eine Symmetrie bezüglich der z-Achse nötig. Gleiches gilt im Übrigen auch für die jeweils mittleren i+1.ten Knoten höherer ungerader $TE_{2i+1}$ oder $TM_{2i+1}$ Moden, welche daher ebenfalls breitbandig nutzbar sind. Die Symmetrie wird außerhalb eines Bereiches der Ausdehnung $2z_c$ gefordert, der die lichtablenkende Struktur 1 und die direkt an die Struktur 1 angrenzenden Materialbereiche mit Brechungsindex $n_{1,-}$ und $n_{1,+}$ vollständig umgibt. Die Schichtanordnungen 2 sind beidseits des Bereichs mit der Ausdehnung $2z_c$ angeordnet und greifen innen teilweise darin ein. Um eine einfachere Schreibweise zu ermöglichen, ist es sinnvoll, die Nullkoordinate z = 0 so zu wählen, dass sie exakt in der Mitte dieses Bereiches liegt. Innerhalb des von der Symmetrieforderung ausgenommenen Bereiches ($-z_c < z < z_c$) muss die Struktur 1 liegen, also insbesondere $z_c \geq z_{s+}$ und $z_{s-} \geq -z_c$ gelten. Da dieser Bereich unsymmetrisch ist, kann die Knotenposition $z_0$ leicht von z = 0 abweichen. Außerhalb dieses Bereiches, also für alle $|z| \geq z_c$ soll Symmetrie gelten. Aufgrund von fertigungsbedingten Ungenauigkeiten ist aber eine leichte Abweichung von dieser Forderung zulässig, die sich im Toleranzfaktor K widerspiegeln soll. Idealerweise ist K = 1. Bei einem schichtweisen Aufbau soll sowohl im inneren, als auch im äußeren Bereich Symmetrie bezüglich der Indizes und der Dicken herrschen: $n_{i,j-} = Kn_{i,j+}$ und $t_{i,j-} = Kt_{i,j+}$ für alle $j$ von 1 bis $M$ und $n_{a,k-} = Kn_{a,k+}$ und $t_{a,k-} = Kt_{a,k+}$ für alle $k$ von 1 bis $N$. An der Grenzfläche (gestrichelte Linie) zwischen der M.ten inneren Schicht und der ersten äußeren Schicht herrscht Totalreflexion. Es gelten also insbesondere $n_{i,M+} > n_{a,1+}$ und $n_{i,M-} > n_{a,1-}$. Im äußeren Bereich klingt die Mode mit zunehmendem Abstand von dieser Grenzfläche ab. Wenn eine $l$.te äußere Schicht einen

Abstand $\sum_{k=1}^{l-1} t_{a,k+} \approx \sum_{k=1}^{l-1} t_{a,k-} > t_i/2$ von dieser Grenzfläche aufweist, so besitzt diese Schicht kaum noch einen Einfluss auf die Mode. Entsprechend dürfen soweit außen liegende Schichten von der Symmetrieforderung abweichen und sie dürfen sogar einen höheren Brechungsindex als $n_{i,M+} \approx n_{i,M-}$ aufweisen. Ohne dieses Enden eines Wellenleiters für hohe $|z|$ wäre ein Stapeln verschiedener Wellenleiter nicht möglich. Wenn die Zahl der Schichten ($N, M$) sehr groß wird, und die Indexunterschiede benachbarter Schichten sowie die Dicken der einzelnen Schichten sehr klein, so kann der schichtweise Aufbau auch zur Beschreibung eines Gradientenwellenleiters genutzt werden. Allerdings ist in diesem Fall ein funktionales $n(z)$ naheliegender. Wird der Übergang zwischen innerem und äußerem Bereich kontinuierlich, erfolgt die Totalreflexion in einem Volumen und nicht mehr an einer Grenzfläche. Dies ist durch die verbreiterte gestrichelte Linie im unteren Bild angedeutet. Dieses gesamte Volumen wird dem Außenbereich zugeordnet.

Für die weit äußeren Bereiche des Wellenleiters, die vom äußersten Rand dieses Volumens mehr als $t_i/2$ weit entfernt sind gelten auch hier keine Symmetrieforderungen mehr. Von dieser Einschränkung abgesehen soll das $n(z)$ für alle $|z| \geq z_c$ symmetrisch sein ($n(z) = Kn(-z)$). Bevorzugt soll K im Bereich 0,99 < K < 1,01, weiter bevorzugt soll K im Bereich 0,999<K<1,001, weiter bevorzugt soll K im Bereich 0,9999<K<1,0001, weiter bevorzugt soll K im Bereich 0,99999<K<1,00001

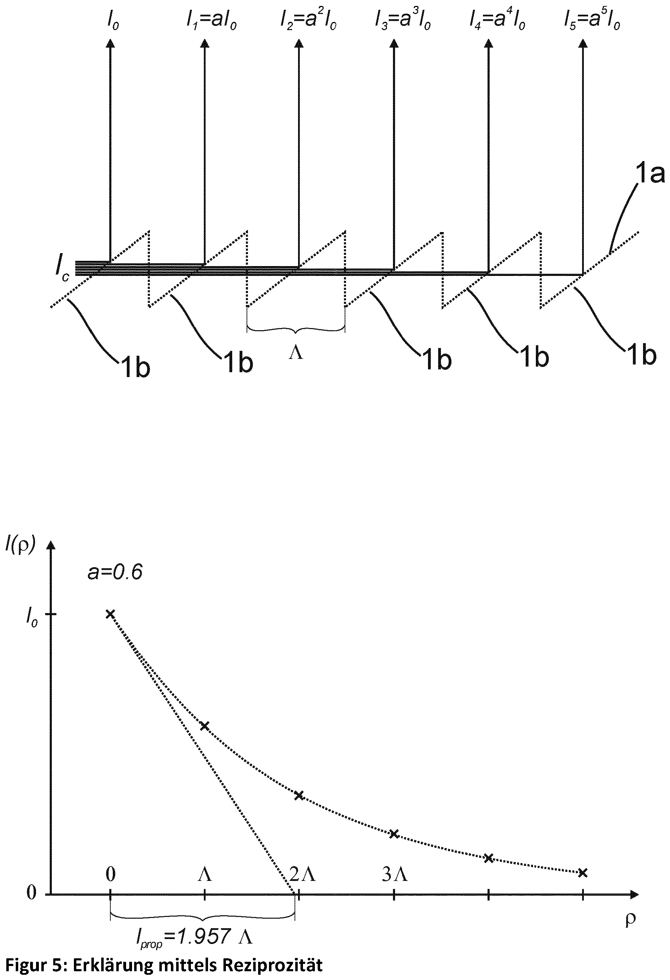

Figur 5 erklärt die Wirkung des erfindungsgemäßen Lichtkonzentrators anhand des Prinzips der Reziprozität. Das aus einem homogenen eindimensionalen Gitterkoppler als Lichtlenker 1a ausgekoppelte Licht besitzt eine exponentielle Intensitätsverteilung $I(x)$. Für optimales Sammeln also für den reziproken Vorgang muss auch das zu sammelnde Licht eine solche Verteilung ausweisen. Um auf großen Längen sammeln zu können muss a klein werden, was durch das Knotenkonzept erreicht wird.

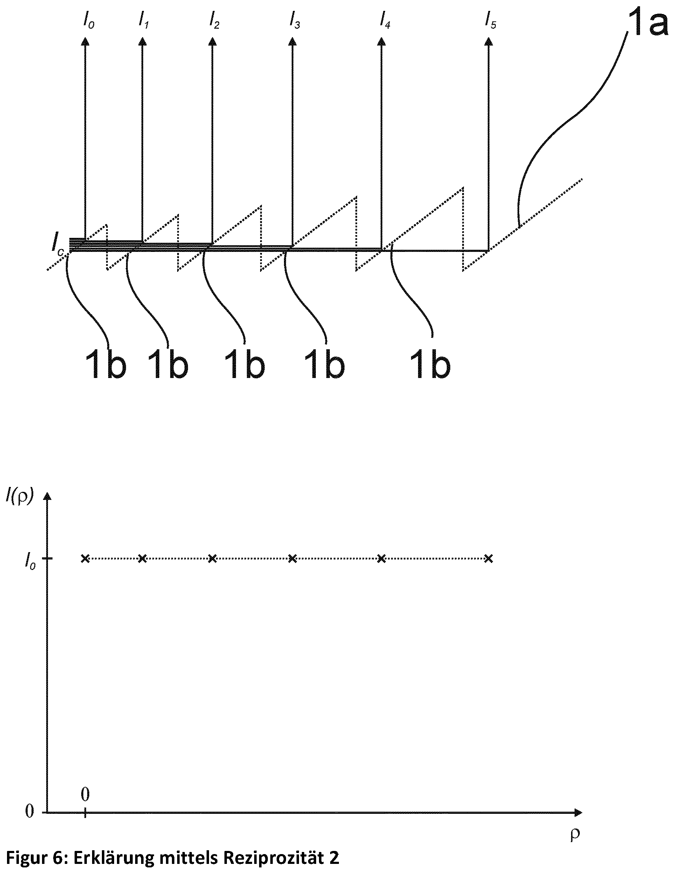

Die Erfindung kann gemäß Figur 6 vorsehen, dass mit zunehmendem radialen Abstand $\rho$ von der Z-Achse die in Z-Richtung betrachtete Höhe und/oder radiale Breite der durch eine Facette 1b gebildeten Stufe eines Lichtlenkers 1a zunimmt.

In einer radialsymmetrischen Anordnung würde die Auskopplung einer von innen zylinderförmig nach außen laufenden Welle eine Abhängigkeit $I(\rho)$ aufweisen, die über den beschriebenen exponentiellen Term noch einen reziprok von $\rho$ abhängigen Faktor aufweist, da die Intensität selbst ohne Auskopplung infolge der größer werdenden durchleuchteten Zylindermantelfläche mit zunehmendem $\rho$ abnehmen würde. Um dieses stark abfallende $I(\rho)$auszugleichen, ist es notwendig, die Höhe der Stufemit zunehmendem $\rho$ steigen zu lassen. Die größte Ausdehnung (bei maximalem $\rho$, also außen in dem Lichtlenker) definiert dann die $t_s$ bzw. die Werte $z_{s-}$ und $z_{s+}$.

Eine solche Ausführung der Lichtlenker ist somit bevorzugt für das Sammeln und Konzentrieren von Sonnenlicht, das mit einer gleichmäßigen Intensitätsverteilung auf einen Wellenleiter der Erfindung einfällt.

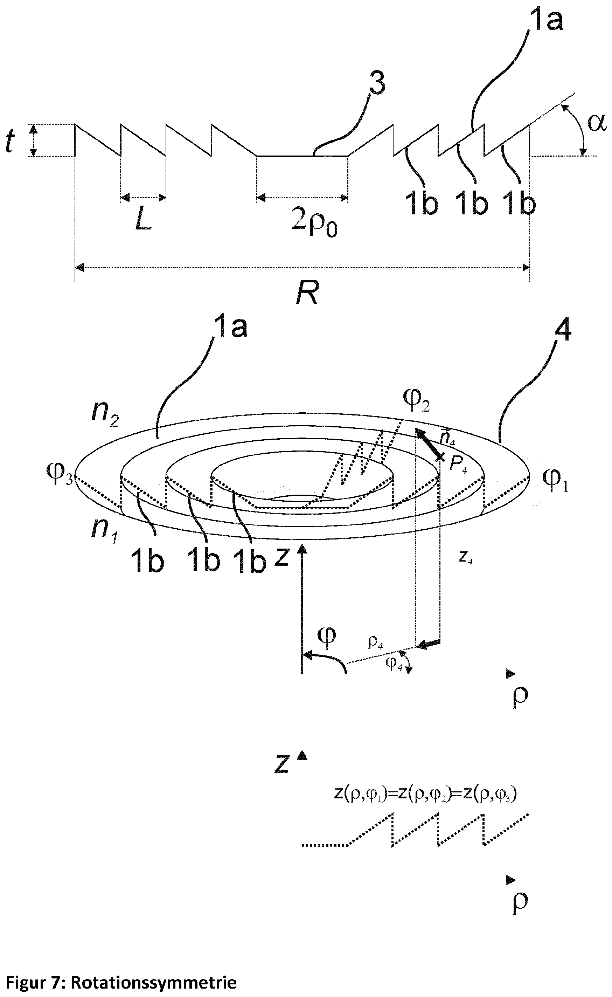

Die Figur 7 zeigt die Ausführung eines als Reflektor ausgebildeten Lichtlenkers 1a aus reflektierenden Facetten 1b, welche ringförmig den Lichtsammelbereich 3 im Zentrum des Lichtlenkers 1a der Struktur 1 umgeben.

Die Facetten 1b können, wie hier gezeigt vollständig rotationssymmetrisch sein während der Rand des Lichtlenkers unabhängig von den im Innenbereich des Lichtlenkers liegenden Facetten geformt sein kann. In diesem Beispiel ist der äußere Rand 4 des Lichtlenkers 1a von Struktur 1 kreisrund. Sinnvoll ist ein Wechsel von kartesischen auf Zylinderkoordinaten. Bei vollständiger Rotationssymmetrie sind die $z(\rho)$ bei allen $\varphi$ gleich. Allgemeiner (auch bei stückweiser Rotationssymmetrie zeigt der Normalenvektor (hier am Beispiel $\vec{n}_4$), abgesehen von den Facettenrändern, exakt auf die z-Achse, was insbesondere bei Projektion in die XY-Ebene auffällt (jeweils fetter Pfeil).

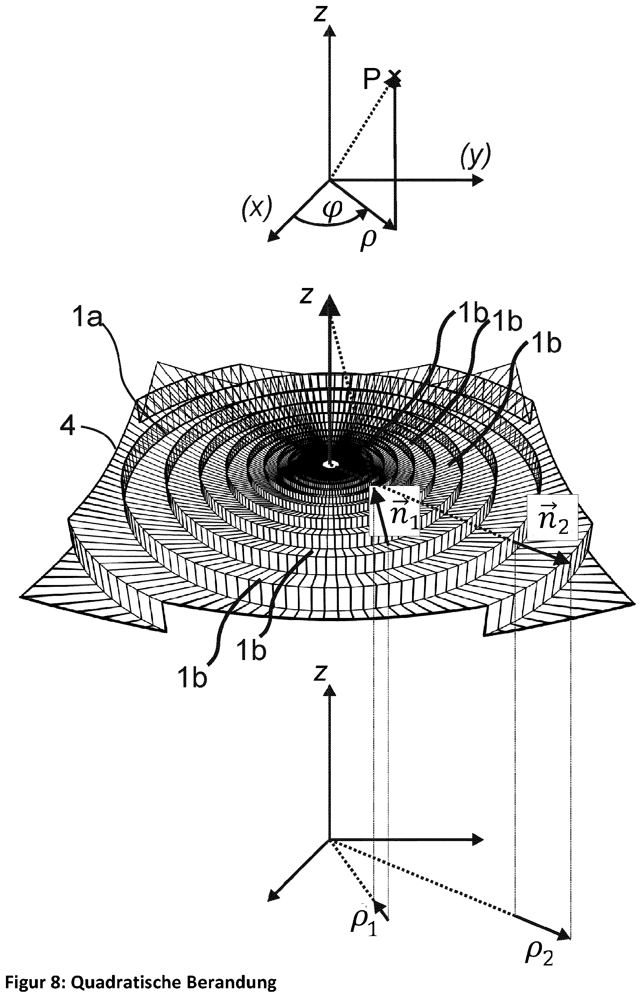

Die Figur 8 zeigt eine Ausführung, bei der die Facetten 1b des Lichtlenkers im Innenbereich des Lichtlenkers 1a rotationssymmetrisch ausgebildet sind. Der äußere Bereich des Lichtlenkers 1a bzw. der Rand 4 und des Lichtlenkers 1a insgesamt ist hingegen quadratisch. Auch hier ist die Ausführung so, dass ausgenommen des Randes 4 die Normalenvektoren auf jeder möglichen Facette 1b des Lichtlenkers 1a der Struktur 1 bei den reflektiv zum Lichtsammelbereich 3 geneigten Facetten genau auf die Z-Achse weisen und bei den vom Lichtsammelbereich abgewandten Flächen von der Z-Achse wegweisen, bzw. die Vektoren im Zylinderkoordinatensystem keine $\varphi$-Komponente aufweisen. Die Facetten sind hier jeweils so ausgebildet, dass sie ringförmig oder zumindest teilringförmig den Lichtsammelbereich 3 umgeben und eine Stufenform aufweisen, mit jeweils einer mit zunehmenden Radialabstand vom Lichtsammelbereich ansteigender Stufenbreite entlang $\rho$ und Stufenhöhe entlang der Z-Achse.

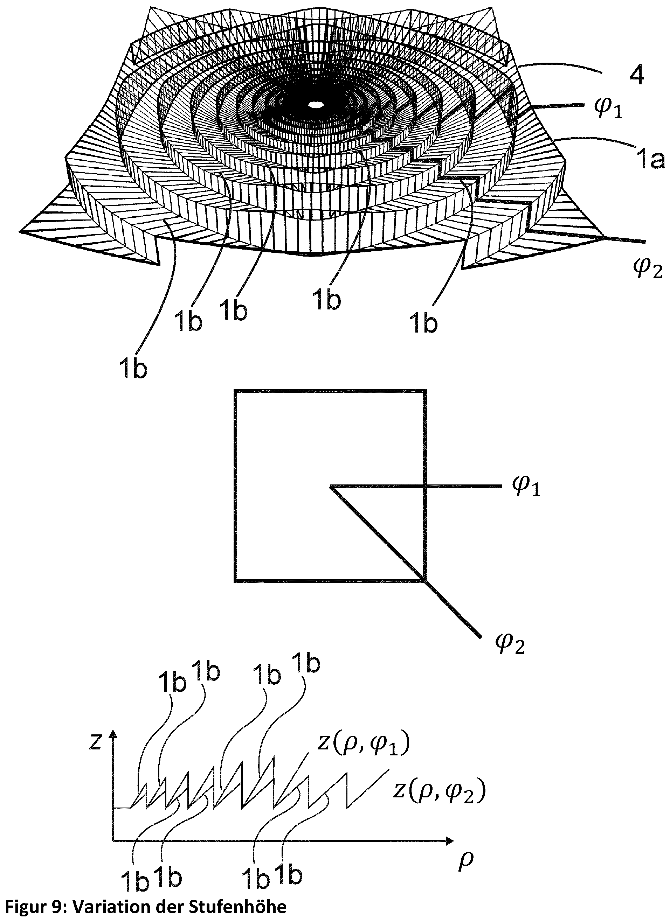

Die Figur 9 zeigt ebenfalls eine quadratisch berandete Ausführung eines Lichtlenkers wie bei der Figur 8, welche vorteilhaft sein kann, um eine Fläche besser mit Lichtlenkern ausnutzen zu können. Dieses bedeutet aber, dass entlang der durch $\varphi_2$ vorgegebenen Richtung eine größere Propagationslänge erreicht werden muss als in der durch $\varphi_1$ vorgegebenen Richtung. Entsprechend werden in der durch $\varphi_2$ vorgegebenen Richtung bei gleichem $\rho$ flachere durch die Facetten 1b gebildete Stufen des Lichtlenkers 1a benötigt, was von null abweichende $\varphi$-Komponenten bedeutet. Hier ist deshalb die Ausführung so, dass die Stufenhöhein Abhängigkeit des Winkels $\varphi$ um die Z-Achse variiert, insbesondere bei konstantem $\rho$ in Richtung zu der Ecke der in der Projektion quadratischen Randes des Lichtlenkers 1a abnimmt.

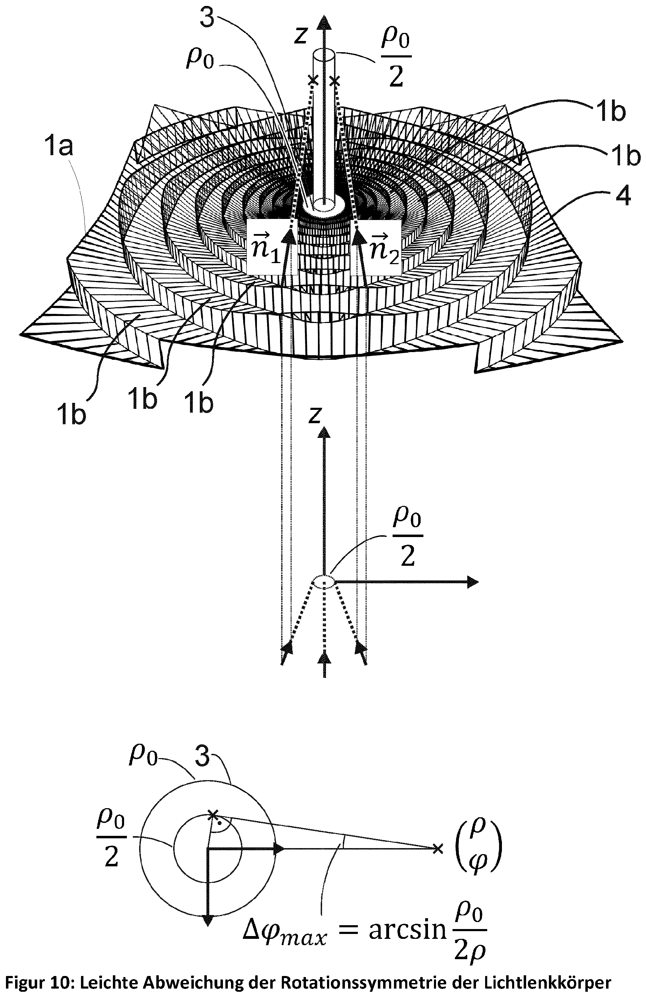

Figur 10 zeigt eine Konkretisierung der von null abweichenden $\varphi$-Komponenten der Normalenvektoren auf den Facetten 1b des Lichtlenkers 1a gemäß Figur 9. Dies ist so zu verstehen, dass die Normalenvektoren auf den reflektierenden Facetten 1b des Lichtlenkers 1a nicht mehr an jeder beliebigen Position einer reflektierenden Fläche exakt auf die Z-Achse weisen. Vorzugsweise ist die Abweichung von der Symmetrie so gewählt, dass die in die Z-Ebene projizierten Normalenvektoren jeder Facette 1b des Lichtlenkers 1a der lichtablenkenden Struktur 1 für jeden betrachten Abstand $\rho$ auf den reflektierenden Flächen zumindest noch in einen durch den halben Durchmesser des Lichtsammelbereiches 3 festgelegten Wertebereich von $\rho \leq \rho_0/2$ weisen, der die Z-Achse mit einem radialen Abstand $\rho_0$ umgibt und somit einen Toleranzbereich der $\varphi$-Komponenten der besagten Normalenvektoren von $|\varphi| \leq \arcsin(\rho_0/2\rho)$ definiert.

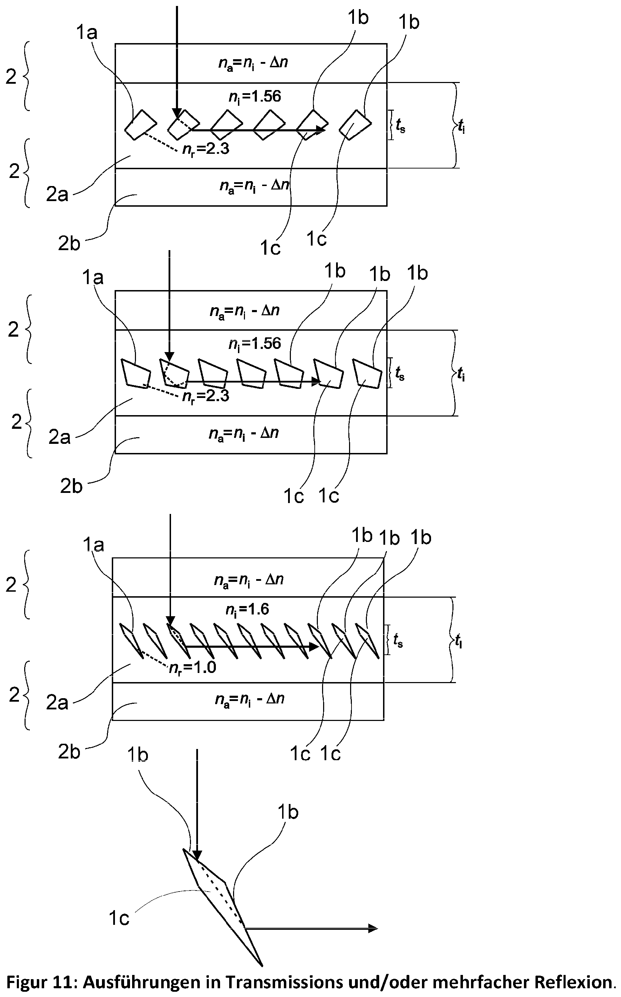

Die Figur 11 zeigt mehrere mögliche Ausführungsvarianten, bei denen die Facetten 1b eines Lichtlenkers 1a nicht eine einzige Reflexion, wie bei den vorherigen Ausführungen, sondern eine lichtbrechende Transmission oder mehrfache Reflexion bewirken.

In den zwei gezeigten transmittierenden Ausführungen werden die Facetten 1b des Lichtlenkers 1a durch Körper 1c mit Brechungsindex $n_r$ gebildet und weisen zwei in Transmission durchleuchtete brechende Facetten 1b auf. Die Körper 1c in den gezeigten transmittierenden Ausführungen können als Bereiche hochbrechenden Materials mit $n_r > n_i$ oder $n_i > n_r$ oder als Materialausnehmung, insbesondere gasgefüllte oder evakuierte Materialausnehmung, in den Schichten des Wellenleiters ausgebildet sein.

In der gezeigten mehrfach reflektiven Ausführung kann es innerhalb der Körper 1c auch zu einer Totalreflexion, insbesondere zweimaligen Totalreflexion und anschließender Transmission aus den Körpern 1c herauskommen. Die Körper 1c können als Bereiche hochbrechenden Materials mit $n_r > n_i$ in den Schichten des Wellenleiters ausgebildet sein.

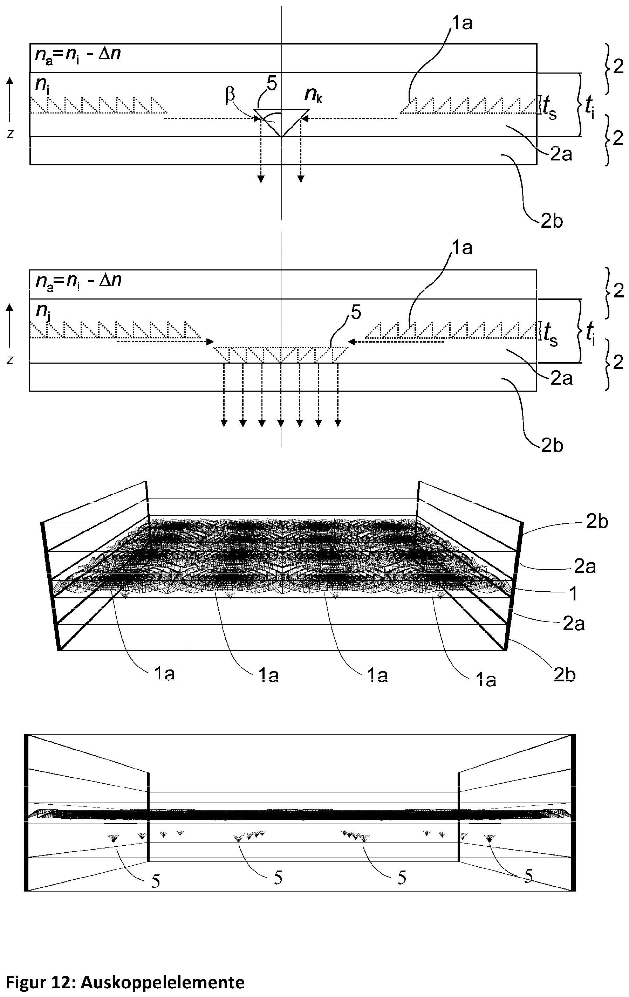

Die Figur 12 zeigt in den oberen zwei Teilbildern zwei verschiedene Ausführungen zur Auskopplung des gesammelten Lichtes mittels eines zum Lichtsammelbereich 3 vom Lichtlenker 1a in negativer Z-Richtung versetzten Auskoppelelementes 5.

In der ersten Variante ist das Auskoppelelement 5 durch eine Materialausnehmung des lichtführenden Mediums mit Brechungsindex $n_i$ in Form eines rotationssymmetrischen Konus mit Öffnungswinkel $\beta$ realisiert, sodass das im Konus befindliche Medium ($n_k$) nahezu oder genau oder zumindest im Wesentlichen einem Brechungsindex von eins entspricht.

Trifft das Licht nun auf die Grenzfläche des Konus, also des Auskoppelementes 5, wird gemäß des Reflexionsgesetzes das im Wellenleiter geführte Licht mit einem vom effektiven Index der Mode und dem Öffnungswinkel $\beta$ abhängigen, durch numerische Simulation bestimmten, Austrittswinkel, wie mittels der schwarzen Pfeile angedeutet, aus dem Konzentrator herausgelenkt.

In der zweiten (Lichtlenker gemäß Figur 9) Variante besteht das Auskoppelelement 5 aus einer in $\rho$ und Z Richtung invertierten Version der Facetten 1b am in Z-Richtung betrachteten Intensitätsmaximum der im Wellenleiter geführten Mode. Hierdurch wird eine effiziente Auskopplung in Einfallsrichtung, wie durch die schwarzen Pfeile angedeutet, bewirkt.

Das dritte und vierte Teilbild zeigt einen gemäß der Figur 9 und dem ersten linken Teilbild kombinierten Wellenleiter mit einer kontaktierend angeordneten Nebeneinanderanordnung von Lichtlenkern sowie konusförmigen Auskoppelelementen 5.

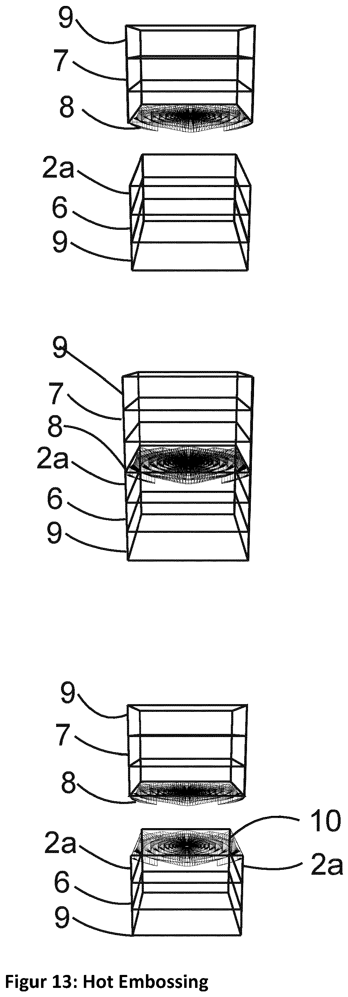

Die Figur 13 zeigt den Abformungsprozess zur Strukturierung des inneren Bereiches des Wellenleiters 2a mittels thermischen Pressens. Der sich auf einem Substrat 6 befindende innere Bereich des Wellenleiters 2a mit Brechungsindex $n_i$ wird unter Druck und Temperatur mit einem mechanisch harten Negativstempel 7 mit einem sich darauf befindenden abzuprägenden negativen Relief (8) zwischen zwei Pressschuhen (9) in Kontakt gebracht, sodass das Material des inneren Bereiches des Wellenleiters unter plastischer Verformung die Form des annimmt und somit ein nun positives Relief 10 aufweist.

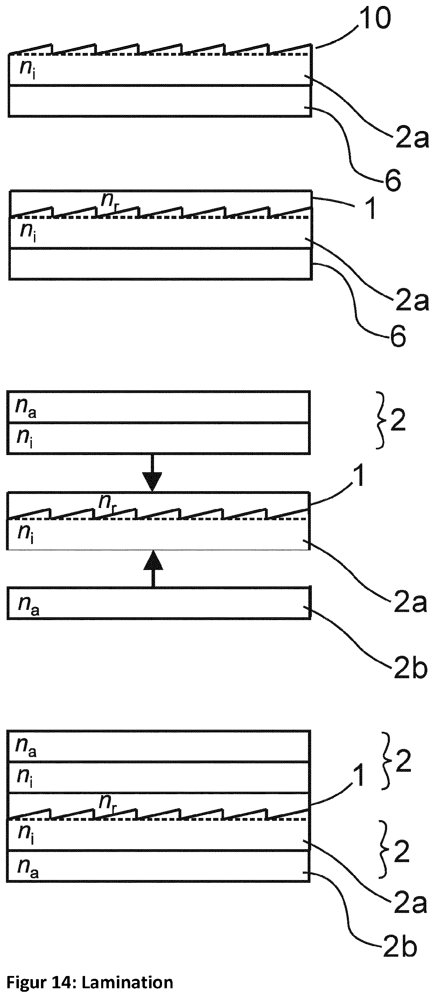

Figur 14 zeigt die Herstellung eines Wellenleiters durch Auffüllen eines durch den Abformungsprozess erzeugten positiven Reliefs 10 gemäß Figur 13 und der anschließenden Erzeugung der Schichtanordnung durch Lamination von Schichten.

Nach der Abformung gemäß Figur 13 liegt wie im ersten Teilbild gezeigt eine Schicht $n_i$ mit einer in Z-Richtung betrachteten unteren glatten Grenzfläche und oberen strukturierten Grenzfläche vor. Die strukturierte Grenzfläche kann nun beispielsweise durch Rotationsbeschichtung mit einer geschlossenen Schicht des Brechungsindex $n_r$ aufgefüllt werden, welche die Struktur 1 samt der Lichtlenker 1a bildet, wobei die Facetten durch die Grenzflächen zwischen den Bereichen mit Brechungsindex $n_i$ und $n_r$ gebildet werden (zweites Teilbild). Nach Ablösung dieser Anordnung vom Substrat 6 wird wie im dritten Teilbild gezeigt auf die Schicht mit Brechungsindex $n_i$ eine weitere Schicht mit Brechungsindex $n_a$ auflaminiert. Auf die bislang exponierten Grenzflächen der Struktur wird hingegen eine Schichtanordnung von zwei Schichten mit den jeweiligen Brechungsindizes $n_i$ und $n_a$ auflamiert, sodass nun bezogen auf eine in der Struktur liegende Mittelebene ein symmetrischer Wellenleiter vorliegt (viertes Teilbild).

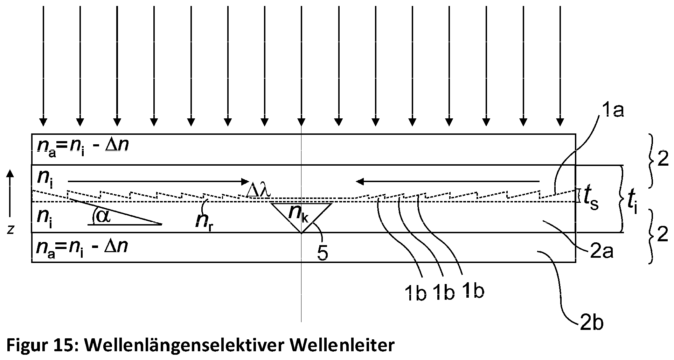

Die Figur 15 zeigt eine Ausführung zur Einrichtung von wellenlängenselektiven Konzentratoren.

Im Querschnitt des rotationssymmetrischen Wellenleiters bildet jede Facette 1b eines Lichtlenkers 1a eine Stufe mit Steigungswinkel $\alpha$.

Numerische Simulationen zeigen, dass das im Wellenleiter konzentrierte Licht einen Spektralbereich der Breite $\Delta\lambda$ aufweist, welcher von diesem Steigungswinkel $\alpha$ und den sonstigen geometrischen und dielektrischen Parametern (Brechungsindex, Schichtdicke, ...) des Wellenleiters abhängt. Zur Anpassung eines Wellenleiters an einen vorbestimmten Spektralbereich wird dieser zur numerischen Berechnung und Optimierung parametrisiert. Das beim Lichtsammelbereich ankommende Spektrum geführten Lichtes dient hierbei als Vergleichsgröße zum gewünschten Spektrum. Mittels einer Variationsoptimierung der Parameter wird so dieses beim Lichtsammelbereich ankommende geführte Licht an das gewünschte Spektrum angeglichen. Die ermittelten Parameter des Wellenleiters dienen im Anschluss als Herstellungsparameter der Wellenleiter.

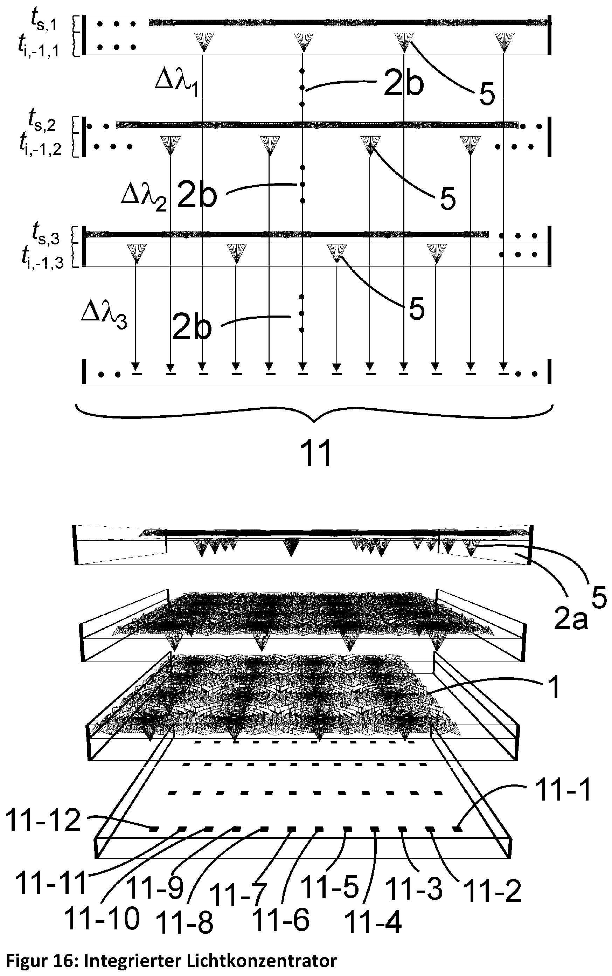

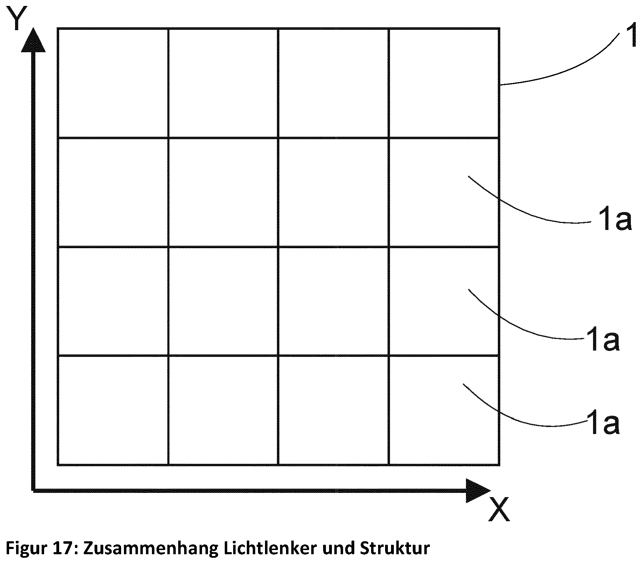

Die Figur 16 zeigt eine für Sonnenlicht optimierte Ausführung eines vollständig integrierten Lichtkonzentrators aus einer Kombination von drei übereinander gestapelten wellenlängenselektierenden Wellenleitern mit einer jeweiligen Nebeneinanderanordnung von Lichtlenkern gemäß der Figuren 12 und 15. Dabei sammelt und konzentriert jeder der drei Wellenleiter einen komplementären Teil des gesamten einfallenden Sonnenspektrums. Zur besseren Übersicht sind nur die jeweiligen lichtablenkenden Strukturen und Auskoppelelemente beinhaltenden Teile der lichtführenden Schicht gezeigt, während die weiteren fortführenden Schichten 2b der Wellenleiter durch die schwarzen Punkte angedeutet sind. Hierbei ist jeder Wellenleiter mit dem hinter der Schichtbezeichnung stehenden Index nummeriert, sodass beispielsweise die Dicke der Struktur 1 des oberen Wellenleiters die Bezeichnung $t_{s,1}$ hat. Unterhalb des vollständig integrierten Lichtkonzentrators befindet sich eine Matrixanordnung von durch schwarze Quader illustrierten Solarzellen 11 bestehend aus n Reihen von Solarzellen. Eine relative laterale Versetzung der Wellenleiter zueinander erlaubt hierbei eine in Versetzungsrichtung zyklischen Ausführung von insgesamt n komplementären Solarzellenreihen 11-1, 11-2 und 11-3, ..., 11-i, 11-i+1, ..., 11-n, mit einer jeweils zum darüber zentrierten wellenlängenselektierenden Wellenleiter angepassten Bandlückenenergie, und somit eine optimierte Konvertierung von gesammelter Lichtenergie in elektrisch nutzbare Energie. Exemplarisch sind in Figur 17 hierbei insgesamt 12 Solarzellenreihen gezeigt, wobei die Punkte im oberen Teilbild die Fortsetzbarkeit in Versetzungsrichtung einer solchen zyklischen Ausführung symbolisieren. Die Solarzellen können hierbei direkt durch Transferdruck oder pick and place aufgebracht werden. Dabei dienen jeweils die entsprechenden Auskoppelelemente als Positioniermarken.

Die Figur 17 veranschaulicht schematisch den Zusammenhang zwischen der lichtablenkenden Struktur 1 und den in einer parallel zur X-Y Ebene durch Quadrate dargestellten Lichtlenkern 1a. In diesem Beispiel ist die lichtablenkende Struktur 1 aus sechszehn Lichtlenkern zusammengesetzt. Allgemein bildet jede Nebeneinanderanordung von beliebigen Lichtlenkern 1a die lichtablenkende Struktur 1.

**Patentansprüche**

1. Lichtkonzentrator umfassend wenigstens einen Wellenleiter, wobei der wenigstens eine Wellenleiter zwischen zwei Schichtanordnungen (2) von jeweils wenigstens zwei in einer Schichtungsrichtung geschichteten, transparenten dielektrischen Schichten eine lichtablenkende Struktur (1) aufweist, mit welcher auf den wenigstens einen Wellenleiter einfallendes Licht wenigstens eines vorbestimmten Wellenlängenbereiches in den Wellenleiter hinein lenkbar ist, wobei in dem Wellenleiter durch Totalreflexion wenigstens eine Mode des wenigstens einen vorbestimmten Wellenlängenbereiches führbar ist, die in der Schichtungsrichtung betrachtet in ihrer Intensitätsverteilung wenigstens ein lokales Intensitätsminimum ($I_{min}$) aufweist, welches innerhalb der lichtablenkenden Struktur (1) angeordnet ist, **dadurch gekennzeichnet, dass** die lichtablenkende Struktur (1), einen Lichtlenker (1a) aufweist oder mehrere Lichtlenker (1a) aufweist, die senkrecht zur Schichtungsrichtung nebeneinander angeordnet sind, wobei ein jeweiliger Lichtlenker (1a) Facetten (1b) aufweist, die jeweils in jeder von drei zueinander senkrechten Raumrichtungen größer als die größte Wellenlänge des vorbestimmten Wellenlängenbereiches ausgebildet sind und mit denen das einfallende Licht in Richtung zu einem dem Lichtlenker (1a) zugeordneten Lichtsammelbereich (3) ablenkbar ist, wobei eine Facette durch eine Grenzfläche zwischen zwei dielektrischen Medien mit unterschiedlichem Brechungsindex gebildet ist, wobei an beiden Übergängen zwischen innerem Bereich (2a) und äußerem Bereich (2b) der Schichtanordnungen (2), an denen die Totalreflexionen dadurch ermöglicht sind, dass am Übergang jeweils ein stufenweise oder räumlich verteilter Übergang vom höheren Brechungsindex im inneren Bereich (2a) zu einem um einen Brechungsindexunterschied reduzierten Brechungsindex im äußeren Bereich (2b) gegeben ist und wobei dieser Brechungsindexunterschied kleiner ist als $1 \times 10^{-3}$.

2. Lichtkonzentrator nach Anspruch 1, **dadurch gekennzeichnet, dass** in Schichtungsrichtung unterhalb oder oberhalb des Lichtsammelbereichs (3) oder eines Auskoppelelementes (5) eine zu beleuchtende Anordnung innerhalb einer Schicht oder auf der Oberfläche einer Schicht des Wellenleiters angeordnet ist, die durch aus dem Lichtsammelbereich (3) oder Auskoppelelement (5) austretendes Licht beleuchtet ist.

3. Lichtkonzentrator nach einem der vorherigen Ansprüche, **dadurch gekennzeichnet, dass** der Lichtsammelbereich (3) durch einen Bereich des Lichtlenkers (1a) in dessen Zentrum ausgebildet ist.

4. Lichtkonzentrator nach einem der vorherigen Ansprüche, **dadurch gekennzeichnet, dass** ein Auskoppelelement (5) zur Auskopplung von Licht

   a. in Z-Richtung betrachtet, in der die Schichten der Schichtanordnungen geschichtet sind, oberhalb oder unterhalb des Lichtsammelbereiches (3) und/oder Lichtlenkers (1a) liegt, oder
   b. als Materialausnehmung der Struktur (1) und/oder wenigstens einer der Wellenleiterschichten ausgeführt ist, oder
   c. als streuende oder beugende oder reflektierende, vorzugsweise totalreflektierende Anordnung ausgeführt ist, welche bezüglich der Schichtungsrichtung zur lichtablenkenden Struktur (1) versetzt ist, mit welcher Licht aus der Richtung einer im Wellenleiter propagierenden Mode ablenkbar ist.

5. Lichtkonzentrator nach einem der vorherigen Ansprüche, **dadurch gekennzeichnet, dass** jeder von mehreren Wellenleitern derart symmetrisch bezüglich der Schichtungsrichtung z ist, dass drei von der Symmetrie ausgenommene Bereiche definiert werden:

   a. erstens ein Bereich des Wellenleiters mit der Ausdehnung $2z_c$, in dem sich die lichtablenkende Struktur (1) befindet und in dessen Mittelebene z=0 liegt,
   b. zweitens die Bereiche , die größer gleich dem halben Wert des in Schichtungsrichtung betrachteten Maßes ($t_i$) der Erstreckung des inneren Bereichs (2a) außerhalb des inneren Bereiches (2a) des Wellenleiters beginnen,

   dass aber abgesehen von vorgenannter Einschränkung der Brechungsindex $n(z)$ für alle $|z| \geq z_c$ symmetrisch ist mit $n(z) = Kn(-z)$, wobei $K$ im Bereich $0{,}99 < K < 1{,}01$ liegt.

6. Lichtkonzentrator nach einem der vorherigen Ansprüche, **dadurch gekennzeichnet, dass** zumindest ein Teil der Facetten (1b) eines Lichtlenkers (1a)einer lichtablenkenden Struktur (1) einen jeweiligen Lichtsammelbereich (3) zumindest teilrahmenförmig umgibt und jeder Lichtlenker (1a) wenigstens eine reflektierende oder totalreflektierende Facette (1b) aufweist oder wenigstens zwei Facetten (1b) aufweist, an denen transmittiertes Licht jeweils gebrochen wird, so dass das auf der Oberfläche eines jeweiligen Lichtlenkers (1a) auftreffende Licht infolge dieser Reflexion oder Totalreflexion oder Brechung in Richtung des jeweiligen Lichtsammelbereiches (3) ablenkbar ist.

7. Lichtkonzentrator nach einem der vorherigen Ansprüche, **dadurch gekennzeichnet, dass** ein jeweiliger Lichtlenker (1a) bei einem angenommenen Ursprung eines Zylinderkoordinatensystems im Mittelpunkt des Lichtsammelbereichs (3) eine oder mehrere die Z-Achse zumindest bereichsweise umgebende reflektierende oder Licht brechende Facetten (1b) aufweist, wobei der Normalenvektor für jeden Ort auf der Facette (1b) eine φ-Komponente von null aufweist.

8. Lichtkonzentrator nach einem der vorherigen Ansprüche, **dadurch gekennzeichnet, dass** die wenigstens eine reflektierende oder Licht brechende Facette (1b) jedes Lichtlenkers (1a) betrachtet in einer Schnittebene, welche die Z-Achse umfasst, eine mit zunehmendem radialen Abstand $\rho$ von der Z-Achse im Z-Wert ansteigende Stufe ausbildet.

9. Lichtkonzentrator nach einem der vorherigen Ansprüche, **dadurch gekennzeichnet, dass** für jeden Ort auf der Facette (1b) des Lichtlenkers (1a) mit demselben radialen Abstand $\rho$ von der Z-Achse bei jedem beliebigen Winkel $\varphi$ der Wert von dessen Koordinate $Z(\rho,\varphi)$ gleich ist.

10. Lichtkonzentrator nach einem der vorherigen Ansprüche, **dadurch gekennzeichnet, dass** mit zunehmendem radialen Abstand $\rho$ von der Z-Achse die in Z-Richtung betrachtete Höhe und/oder radiale Breite der Stufen eines jeweiligen Lichtlenkers (1a) zunimmt.

11. Lichtkonzentrator nach einem der vorherigen Ansprüche, **dadurch gekennzeichnet, dass** ein jeweiliger Lichtlenker (1a) bei einer Projektion in Z-Richtung betrachtet hinsichtlich seines radial äußeren begrenzenden Randes (4) kreisförmig ausgebildet ist.

12. Lichtkonzentrator nach einem der vorherigen Ansprüche 1 bis 10, **dadurch gekennzeichnet, dass** ein Lichtlenker (1a) bei einer Projektion in Z-Richtung betrachtet hinsichtlich seines äußeren begrenzenden Randes (4) mehreckig ausgebildet ist.

13. Lichtkonzentrator nach einem der vorherigen Ansprüche, **dadurch gekennzeichnet, dass** innerhalb einer lichtablenkenden Struktur (1) mehrere Lichtlenker (1a) in einer Ebene liegen, deren Ränder (4) einander kontaktierend angeordnet sind.

14. Lichtkonzentrator nach einem der vorherigen Ansprüche, **dadurch gekennzeichnet, dass** die Stufenhöhe wenigstens einer Facette (1b) eines Lichtlenkers (1a) in Umfangsrichtung um die Z-Achse variiert.

15. Lichtkonzentrator nach einem der vorherigen Ansprüche, **dadurch gekennzeichnet, dass** jeder Lichtlenker (1a) aus einem transparenten dielektrischen Medium ausgebildet ist und eine reflektierende oder Licht brechende Fläche des Lichtlenkers (1a) durch eine zusammenhängende strukturierte Grenzfläche zwischen dem Lichtlenker (1a) und dem daran angrenzenden Material des Wellenleiters ausgebildet ist.

16. Lichtkonzentrator nach einem der vorherigen Ansprüche, **dadurch gekennzeichnet, dass** der Brechungsindexunterschied zwischen dem inneren Bereich (2a) und dem äußeren Bereich (2b) einer jeweiligen Schichtanordnung (2) erreicht ist durch unterschiedliche Dotierung desselben Wirtsmaterials.

17. Lichtkonzentrator nach einem der vorherigen Ansprüche, **dadurch gekennzeichnet, dass** in einem Stapel von wenigstens zwei symmetrischen Wellenleitern, die jeweils eine lichtablenkende Struktur (1) umfassen, die in Stapelungsrichtung sich überdeckenden lichtablenkenden Strukturen (1) verschiedener Wellenleiter zueinander senkrecht zur Stapelungsrichtung versetzte Lichtsammelbereiche (3) und entsprechend versetzte Auskoppelelemente (5) aufweisen.

18. Lichtkonzentrator nach einem der vorherigen Ansprüche, **dadurch gekennzeichnet, dass** die Schichten des Wellenleiters durch aufeinander laminierte Polymerfilme gebildet sind.

19. Lichtkonzentrator nach einem der vorherigen Ansprüche, **dadurch gekennzeichnet, dass** ein jeweiliger Lichtlenker (1a) durch einen Übergang eines Reliefs (10) aus Facetten (1b) an der Oberfläche eines dielektrischen Mediums zu einem anderen dieses Relief (10) vollständig bedeckenden anderen dielektrischen Medium oder einem Hohlraum in wenigstens einer der Schichten einer Schichtanordnung (2) ausgebildet ist.

## Claims

1. Light concentrator comprising at least one waveguide, wherein the at least one waveguide comprises a light-deflecting structure (1) which is located between two layer arrangements (2) of in each case at least two transparent dielectric layers layered in a layering direction and by means of which light from at least one predetermined wavelength range incident on the at least one waveguide can be steered into the waveguide, wherein at least one mode from the at least one predetermined wavelength range can be guided in the waveguide by total-internal reflection, the intensity distribution of said mode having, as viewed in the layering direction, at least one local intensity minimum ($I_{min}$) which is arranged within the light-deflecting structure (1), **characterized in that** the light-deflecting structure (1) comprises a light guide (1a) or multiple light guides (1a) arranged next to one another perpendicular to the layering direction, wherein a respective light guide (1a) comprises facets (1b) which are each embodied to be longer than the longest wavelength from the predetermined wavelength range in each of three mutually perpendicular spatial directions and by means of which the incident light can be deflected in the direction of a light collection region (3) assigned to the light guide (1a), wherein a facet is formed by an interface between two dielectric media with different refractive indices, wherein at both transitions between the inner region (2a) and the outer region (2b) of the layer arrangements (2) at which the total-internal reflections are made possible by virtue of there being, at the transition, in each case a stepwise or spatially distributed transition from the higher refractive index in the inner region (2a) to a refractive index in the outer region (2b) which has been reduced by a refractive index difference, and wherein this refractive index difference is less than $1\times10^{-3}$.

2. Light concentrator according to Claim 1, **characterized in that**, in the layering direction below or above the light collection region (3) or an output coupling element (5), an arrangement to be illuminated is arranged within a layer or on the surface of a layer of the waveguide and illuminated by light emerging from the light collection region (3) or output coupling element (5).

3. Light concentrator according to either of the preceding claims, **characterized in that** the light collection region (3) is formed by a region of the light guide (1a) in the centre thereof.

4. Light concentrator according to any of the preceding claims, **characterized in that** an output coupling element (5) for output coupling light

   a. is located above or below the light collection region (3) and/or light guide (1a) when viewed in the Z-direction, in which the layers of the layer arrangements are layered, or
   b. is designed as a material cutout of the structure (1) and/or at least one of the waveguide layers, or
   c. is designed as a scattering or diffracting or reflecting arrangement, preferably as a total-internal reflection arrangement, which with respect to the layering direction is offset from the light-deflecting structure (1) with which light can be deflected from the direction of a mode propagating in the waveguide.

5. Light concentrator according to any of the preceding claims, **characterized in that** each of a plurality of waveguides is symmetric in such a way with respect to the layering direction z that three regions excluded from the symmetry are defined:

   a. firstly, a region of the waveguide with the extent $2z_c$, in which the light-deflecting structure (1) is situated and in the centre plane of which z=0 is located,
   b. secondly, the regions which start at greater than or equal to half the value of the dimension ($t_i$) of the extent of the inner region (2a) outside the inner region (2a) of the waveguide, as viewed in the layering direction,

   but that, apart from the above-mentioned restriction, the refractive index n(z) is symmetric for all $|z| \geq z_c$, where n(z) = Kn(-z), where K is in the range 0.99 < K < 1.01.

6. Light concentrator according to any of the preceding claims, **characterized in that** at least some of the facets (1b) of a light guide (1a) of a light-deflecting structure (1) surround a respective light collection region (3) in an at least partially frame-shaped manner, and each light guide (1a) comprises at least one reflective or total-internal reflection facet (1b) or comprises at least two facets (1b) at which transmitted light is refracted in each case such that the light incident on the surface of a respective light guide (1a) can be deflected in the direction of the respective light collection region (3) as a result of this reflection or total-internal reflection or refraction.

7. Light concentrator according to any of the preceding claims, **characterized in that** given an assumed origin of a cylindrical coordinate system at the centre of the light collection region (3), a respective light guide (1a) comprises one or more reflective or light-refracting facets (1b) which surround the Z-axis at least in regions, wherein the normal vector has a φ component of zero for each location on the facet (1b).

8. Light concentrator according to any of the preceding claims, **characterized in that** the at least one reflective or light-refracting facet (1b) of each light guide (1a), as viewed in a sectional plane comprising the Z-axis, forms a step which increases in Z-value with increasing radial distance ρ from the Z-axis.

9. Light concentrator according to any of the preceding claims, **characterized in that** for any location on the facet (1b) of the light guide (1a) with the same radial distance ρ from the Z-axis at any angle φ, the value of the coordinate $Z(\rho,\varphi)$ thereof is the same.

10. Light concentrator according to any of the preceding claims, **characterized in that** the height, as viewed in the Z-direction, and/or radial width of the steps of a respective light guide (1a) increase with increasing radial distance ρ from the Z-axis.

11. Light concentrator according to any of the preceding claims, **characterized in that** when viewed in a projection in the Z-direction, a respective light guide (1a) is of circular form with respect to its radially outer delimiting edge (4).

12. Light concentrator according to any of preceding Claims 1 to 10, **characterized in that** when viewed in a projection in the Z-direction, a light guide (1a) is of polygonal form with respect to its outer delimiting edge (4).

13. Light concentrator according to any of the preceding claims, **characterized in that** within a light-deflecting structure (1), a plurality of light guides (1a) are located in a plane and their edges (4) are arranged so as to make contact with one another.

14. Light concentrator according to any of the preceding claims, **characterized in that** the step height of at least one facet (1b) of a light guide (1a) varies in the circumferential direction about the Z-axis.

15. Light concentrator according to any of the preceding claims, **characterized in that** each light guide (1a) is formed from a transparent dielectric medium, and a reflective or light-refracting surface of the light guide (1a) is formed by a continuous structured interface between the light guide (1a) and the material of the waveguide adjacent thereto.

16. Light concentrator according to any of the preceding claims, **characterized in that** the refractive index difference between the inner region (2a) and the outer region (2b) of a respective layer arrangement (2) is obtained by different doping of the same host material.

17. Light concentrator according to any of the preceding claims, **characterized in that** in a stack of at least two symmetric waveguides which each comprise a light-deflecting structure (1), the light-deflecting structures (1) of different waveguides which overlap one another in the stacking direction have light collection regions (3) offset with respect to one another perpendicular to the stacking direction and correspondingly offset output coupling elements (5).

18. Light concentrator according to any of the preceding claims, **characterized in that** the layers of the waveguide are formed by polymer films laminated onto one another.

19. Light concentrator according to any of the preceding claims, **characterized in that** a respective light guide (1a) is formed by a transition of a relief (10) of facets (1b) on the surface of a dielectric medium to another other dielectric medium completely covering this relief (10) or a cavity in at least one of the layers of a layer arrangement (2).

**Revendications**

1. Concentrateur de lumière comprenant au moins un guide d'ondes, ledit au moins un guide d'ondes présentant une structure de déviation de lumière (1) entre deux ensembles de couches (2) respectivement constituées d'au moins deux couches diélectriques transparentes empilées dans une direction d'empilement, au moyen de laquelle une lumière incidente sur le guide d'ondes d'au moins une plage de longueurs d'ondes prédéterminée peut être déviée vers le guide d'ondes, au moins un mode de ladite au moins une plage de longueurs d'onde prédéterminée pouvant être guidé dans le guide d'ondes par réflexion totale et présentant, lorsqu'on l'observe dans la direction d'empilement, au moins un minimum d'intensité local ($I_{min}$) dans sa distribution d'intensité, lequel se situe à l'intérieur de la structure de déviation de lumière (1), **caractérisé en ce que** la structure de déviation de lumière (1) comporte un guide de lumière (1a) ou plusieurs guides de lumière (1a) disposés les uns à côté des autres perpendiculairement à la direction d'empilement, un guide de lumière (1a) respectif présentant des facettes (1b) qui sont respectivement de dimensions supérieures à la plus grande longueur d'onde de la plage de longueurs d'onde prédéterminée dans trois directions spatiales perpendiculaires les unes aux autres et au moyen desquelles la lumière incidente peut être déviée en direction d'une zone collectrice de lumière (3) associée au guide de lumière (1a), une facette étant formée par une interface entre deux milieux diélectriques d'indices de réfraction différents, dans lequel aux deux transitions entre la zone intérieure (2a) et la zone extérieure (2b) des ensembles de couches (2) auxquelles les réflexions totales sur celles-ci sont rendues possibles en raison du fait qu'il se produit respectivement au niveau de la transition une transition échelonnée ou spatialement distribuée de l'indice de réfraction le plus élevé dans la zone intérieure (2a) à un indice de réfraction dans la zone extérieure (2b) qui est réduit d'une différence d'indice de réfraction, cette différence d'indice de réfraction étant inférieure à $1\times10^{-3}$.

2. Concentrateur de lumière selon la revendication 1, **caractérisé en ce que**, dans la direction d'empilement, au-dessous ou au-dessus de la zone collectrice de lumière (3) ou d'un élément d'extraction (5), un dispositif à éclairer est disposé à l'intérieur d'une couche ou sur la surface d'une couche du guide d'ondes, qui est éclairée par la lumière sortant de la zone collectrice de lumière (3) ou de l'élément d'extraction (5).

3. Concentrateur de lumière selon l'une des revendications précédentes, **caractérisé en ce que** la zone collectrice de lumière (3) est formée par une zone du guide de lumière (1a) se trouvant au centre de celui-ci.

4. Concentrateur de lumière selon l'une des revendications précédentes, **caractérisé en ce qu'**il est prévu un élément d'extraction (5) pour l'extraction de lumière

   a. qui, lorsqu'on l'observe dans la direction Z dans laquelle les couches des ensembles de couches sont empilées, se trouve au-dessus ou au-dessous de la zone collectrice de lumière (3) et/ou du guide de lumière (1a), ou
   b. qui est réalisé sous la forme d'un évidement de matériau de la structure (1) et/ou d'au moins l'une des couches de guide d'ondes, ou
   c. qui est réalisé sous la forme d'un dispositif diffusant ou diffractant ou réfléchissant, de préférence totalement réfléchissant, qui est décalé par rapport à la direction d'empilement et par rapport à la structure de déviation de lumière (1), au moyen duquel la lumière peut être déviée par rapport à la direction d'un mode de propagation dans le guide d'ondes.

5. Concentrateur de lumière selon l'une des revendications précédentes, **caractérisé en ce que** chacun de plusieurs guides d'ondes est symétrique par rapport à la direction d'empilement z de telle sorte que trois zones exclues de la symétrie sont définies :

   a. en premier lieu, une zone du guide d'ondes d'étendue $2z_c$, dans laquelle se trouve la structure de déviation de lumière (1) et qui se situe dans le plan médian z=0 de celle-ci,
   b. en second lieu, les zones dont la dimension commence à être supérieure ou égale à la moitié de la valeur de la dimension ($t_i$), observée dans la direction d'empilement, de l'étendue de la zone intérieure (2a) à l'extérieur de la zone intérieure (2a) du guide d'ondes, de sorte que, outre la restriction précitée, l'indice de réfraction n(z) est symétrique pour tous les z tels que $|z| \geq z_c$, avec n(z) = Kn(-z), où K se situe dans la plage 0,99 < K < 1,01.

6. Concentrateur de lumière selon l'une des revendications précédentes, **caractérisé en ce qu'**au moins certaines des facettes (1b) d'un guide de lumière (1a) d'une structure de déviation de lumière (1) entourent au moins partiellement une zone collectrice de lumière (3) et chaque guide de lumière (1a) présente au moins une facette réfléchissante ou totalement réfléchissante (1b) ou au moins deux facettes (1b) sur lesquelles la lumière transmise est respectivement réfractée, de sorte que la lumière incidente sur la surface d'un guide de lumière (1a) respectif peut être déviée en direction de la zone collectrice de lumière (3) respective en raison de cette réflexion ou de cette réflexion totale ou de cette réfraction.

7.   Concentrateur de lumière selon l'une des revendications précédentes, **caractérisé en ce qu'**un guide de lumière (1a) respectif présente, au niveau d'une origine supposée d'un système de coordonnées cylindriques au centre de la zone collectrice de lumière (3), une ou plusieurs facettes réfléchissantes ou optiquement réfringentes (1b) entourant l'axe Z au moins dans certaines zones, le vecteur normal présentant une composante φ égale à zéro pour chaque emplacement sur la facette (1b).

8.   Concentrateur de lumière selon l'une des revendications précédentes, **caractérisé en ce que** ladite au moins une facette réfléchissante ou optiquement réfringente (1b) de chaque guide de lumière (1a) forme, lorsqu'on l'observe dans un plan de coupe comprenant l'axe Z, un échelon dont la valeur Z augmente lorsque la distance radiale ρ par rapport à l'axe Z augmente.

9.   Concentrateur de lumière selon l'une des revendications précédentes, **caractérisé en ce que**, pour chaque emplacement sur la facette (1b) du guide de lumière (1a) présentant la même distance radiale ρ par rapport à l'axe Z pour un angle quelconque φ, la valeur de sa coordonnée $Z(\rho,\varphi)$ est identique.

10.   Concentrateur de lumière selon l'une quelconque des revendications précédentes, **caractérisé en ce que**, lorsque la distance radiale ρ par rapport à l'axe Z augmente, la hauteur et/ou la largeur radiale des échelons d'un guide de lumière (1a) respectif, lorsqu'on l'observe dans la direction Z, augmente.

11.   Concentrateur de lumière selon l'une des revendications précédentes, **caractérisé en ce que**, lorsqu'on l'observe en projection dans la direction Z, un guide de lumière (1a) respectif est conçu sous forme circulaire en ce qui concerne son bord de délimitation radialement extérieur (4).

12.   Concentrateur de lumière selon l'une des revendications 1 à 10 précédentes, **caractérisé en ce que**, en projection dans la direction Z, un guide de lumière (1a) est conçu sous forme polygonale en ce qui concerne son bord de délimitation extérieur (4).

13.   Concentrateur de lumière selon l'une des revendications précédentes, **caractérisé en ce que** plusieurs guides de lumière (1a) sont disposés dans un plan à l'intérieur d'une structure de déviation de lumière (1), dont les bords (4) sont disposés en contact les uns avec les autres.

14.   Concentrateur de lumière selon l'une des revendications précédentes, **caractérisé en ce que** la hauteur d'échelon d'au moins une facette (1b) d'un guide de lumière (1a) varie dans la direction circonférentielle autour de l'axe Z.

15.   Concentrateur de lumière selon l'une des revendications précédentes, **caractérisé en ce que** chaque guide de lumière (1a) est constitué d'un milieu diélectrique transparent et **en ce qu'**une surface réfléchissante ou optiquement réfringente du guide de lumière (1a) est formée par une interface structurée contiguë entre le guide de lumière (1a) et le matériau du guide d'onde adjacent à celui-ci.

16.   Concentrateur de lumière selon l'une des revendications précédentes, **caractérisé en ce que** la différence d'indice de réfraction entre la zone intérieure (2a) et la zone extérieure (2b) d'un ensemble de couches (2) respectif est obtenue par dopage différent du même matériau hôte.

17.   Concentrateur de lumière selon l'une des revendications précédentes, **caractérisé en ce que**, dans un empilement d'au moins deux guides d'ondes symétriques qui présentent respectivement une structure de déviation de lumière (1), les structures de déviation de lumière (1) de différents guides d'ondes qui se chevauchent dans la direction d'empilement présentent des zones de collecte de lumière (3) décalées les unes par rapport aux autres perpendiculairement à la direction d'empilement et des éléments d'extraction (5) décalés de manière correspondante.

18.   Concentrateur de lumière selon l'une des revendications précédentes, **caractérisé en ce que** les couches du guide d'ondes sont formées par des films polymères stratifiés les uns sur les autres.

19.   Concentrateur de lumière selon l'une des revendications précédentes, **caractérisé en ce qu'**un guide de lumière (1a) respectif est formé par une transition d'un relief (10) depuis des facettes (1b) situées sur la surface d'un milieu diélectrique vers un autre autre milieu diélectrique recouvrant complètement ce relief (10) ou une cavité située dans au moins l'une des couches d'un ensemble de couches (2).

**Figur 1: Reflexion in nullter Ordnung, Beugung in $\pm$1. Ordnung**

Fig. 2. Verringerte Führung

Fig. 3. Mode, Knotenebene, Füllfaktor

**Fig. 4. Symmetrie**

$I_0$   $I_1=aI_0$   $I_2=a^2I_0$   $I_3=a^3I_0$   $I_4=a^4I_0$   $I_5=a^5I_0$

1a

$I_c$

1b   1b   $\Lambda$   1b   1b   1b

$I(\rho)$

$a=0.6$

$I_0$

0   $\Lambda$   $2\Lambda$   $3\Lambda$   $\rho$

$I_{prop}=1.957\ \Lambda$

Figur 5: Erklärung mittels Reziprozität

$I_0$  $I_1$  $I_2$  $I_3$  $I_4$  $I_5$

1a

$I_c$

1b  1b  1b  1b  1b

$I(\rho)$

$I_0$

0

0

$\rho$

**Figur 6: Erklärung mittels Reziprozität 2**

**Figur 7: Rotationssymmetrie**

$$z(\rho,\varphi_1)=z(\rho,\varphi_2)=z(\rho,\varphi_3)$$

**Figur 8: Quadratische Berandung**

4
$\varphi_1$
1a
$\varphi_2$
1b
1b
1b
1b
1b

$\varphi_1$
$\varphi_2$

1b 1b    1b 1b

$z$
$z(\rho, \varphi_1)$
$z(\rho, \varphi_2)$
$\rho$
1b 1b    1b 1b

**Figur 9: Variation der Stufenhöhe**

$$\Delta\varphi_{max} = \arcsin\frac{\rho_0}{2\rho}$$

**Figur 10: Leichte Abweichung der Rotationssymmetrie der Lichtlenkkörper**

**Figur 11: Ausführungen in Transmissions und/oder mehrfacher Reflexion.**

Figur 12: Auskoppelelemente

**Figur 13: Hot Embossing**

Figur 14: Lamination

Figur 15: Wellenlängenselektiver Wellenleiter

Figur 16: Integrierter Lichtkonzentrator

**Figur 17: Zusammenhang Lichtlenker und Struktur**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3164744 A1
- EP 2061092 A1